(19) Europäisches Patentamt
European Patent Office
Office européen des brevets

(11) **EP 4 756 869 A1**

(12) **EUROPEAN PATENT APPLICATION**
published in accordance with Art. 153(4) EPC

(43) Date of publication:
**10.06.2026 Bulletin 2026/24**

(21) Application number: **23947475.2**

(22) Date of filing: **28.07.2023**

(51) International Patent Classification (IPC):
**H01L 23/12** (2006.01)   **H05K 1/09** (2006.01)
**H05K 3/46** (2006.01)   **H10N 60/80** (2023.01)

(52) Cooperative Patent Classification (CPC):
**H10N 69/00; H05K 1/0207; H05K 1/09;
H10W 70/60; H10W 70/63; H10W 70/668;**
H05K 1/0206; H05K 1/0243; H05K 1/113;
H05K 2201/10734

(86) International application number:
**PCT/JP2023/027712**

(87) International publication number:
**WO 2025/027675 (06.02.2025 Gazette 2025/06)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **FUJITSU LIMITED**
**Kawasaki-shi, Kanagawa 211-8588 (JP)**

(72) Inventor: **FUKUMORI, Taiga**
**Kawasaki-shi, Kanagawa 211-8588 (JP)**

(74) Representative: **Haseltine Lake Kempner LLP
Cheapside House
138 Cheapside
London EC2V 6BJ (GB)**

(54) **QUANTUM DEVICE AND PRODUCTION METHOD FOR MULTILAYER WIRING BOARD**

(57)    A quantum device includes a multilayer wiring substrate including a first wiring including a superconducting material, a second wiring including a normal conducting material, and a via connected to the second wiring and including a normal conducting material, and a quantum chip provided on a first surface of the multilayer wiring substrate and electrically connected to the first wiring and the via, wherein the via is formed so as to penetrate from the first surface to a second surface of the multilayer wiring substrate, and the second wiring is formed so as to be exposed on the second surface of the multilayer wiring substrate. This makes it possible to reduce the loss of the high frequency signal while ensuring the coolability of the quantum device.

[FIG. 9]

FIG. 9

**Description**

[Technical Field]

The present invention relates to a quantum device and a method of manufacturing a multilayer wiring substrate.

[Background Art]

A strip line is known as a transmission line for a high frequency signal. For example, a high frequency signal delay line is known which is formed of a strip line in which a signal wiring is formed of a superconducting material and a ground wiring is formed of a normal conducting material (for example, Patent Literature 1). Further, it is also known that both the signal wiring and the ground wiring are formed of a superconducting material (for example, Patent Literature 2). Further, it is also known that a signal wiring is formed of an internal normal conductive film and superconducting films in outer peripheral portions, and a ground wiring is formed of a superconducting film on a circuit pattern side and a normal conductive film on an opposite side (for example, Patent Literature 3).

[Citation List]

[Patent Literature]

Patent Literature 1: Japanese Patent Application Publication No. 05-226901
Patent Literature 2: Japanese National Publication of International Patent Application No. 2020-535660
Patent Literature 3: Japanese Patent Application Publication No. 10-224110

[Summary of Invention]

[Technical Problem]

A superconducting quantum computer including a quantum device that operates in a superconducting state under a cryogenic temperature has been developed. As a quantum device, a configuration in which a quantum chip is provided on a multilayer wiring substrate has been proposed. In this case, in order to reduce the loss of the high frequency signal, it is conceivable to form the signal wiring and the ground wiring provided in the multilayer wiring substrate with a superconducting material. However, the thermal resistance of the superconducting material becomes very high at the cryogenic temperature. Therefore, when the multilayer wiring substrate is disposed on the cooling plate in order to cool the quantum chip to the cryogenic temperature, the thermal resistance of the signal wiring and the ground wiring becomes extremely high, and the quantum chip may not be cooled to the cryogenic temperature.

In one aspect, the object of the present disclosure is to reduce the loss of a high frequency signal while ensuring the coolability of a quantum device.

[Solution to Problem]

In one aspect, there is provided a quantum device including: a multilayer wiring substrate including a first wiring including a superconducting material, a second wiring including a normal conducting material, and a via connected to the second wiring and including a normal conducting material; and a quantum chip provided on a first surface of the multilayer wiring substrate and electrically connected to the first wiring and the via; wherein the via is formed so as to penetrate from the first surface to a second surface of the multilayer wiring substrate, and the second wiring is formed so as to be exposed on the second surface of the multilayer wiring substrate.

In one aspect, there is provided a quantum device including: a multilayer wiring substrate including a first wiring including a superconducting material, a second wiring including a superconducting material to which a magnetic material is added, and a via connected to the second wiring and including a superconducting material to which a magnetic material is added; and a quantum chip provided on a first surface of the multilayer wiring substrate and electrically connected to the first wiring and the via; wherein the via is formed so as to penetrate from the first surface to a second surface of the multilayer wiring substrate, and the second wiring is formed so as to be exposed on the second surface of the multilayer wiring substrate.

In one aspect, there is provided a method of manufacturing a multilayer wiring substrate including: forming a multilayer body in which a signal wire including a superconducting material and a plurality of ground wirings including normal a conducting material are laminated with a plurality of insulating layers interposed therebetween, wherein a first ground wiring out of the plurality of ground wirings is exposed on a first surface of the multilayer body and a second ground wiring out of the plurality of ground wirings is exposed on a second surface opposite to the first surface; and forming a ground via in the multilayer body, the ground via including a normal conducting material and connecting the first ground wiring and the second ground wiring.

[Advantageous Effects of Invention]

As one aspect, it is possible to reduce a loss while ensuring a coolability.

[Brief Description of Drawings]

[FIG. 1] FIG. 1 is a cross-sectional view of a quantum device according to a first embodiment.
[FIG. 2] FIG. 2(a) is a plan view of a quantum bit provided in a quantum chip in the first embodiment, FIG. 2(b) is a plan view of a Josephson junction element, and FIG. 2(c) is a cross-sectional view taken along a line A-A in FIG. 2(b).
[FIG. 3] FIG. 3(a) to FIG. 3(d) are exploded plan views of a printed substrate in the first embodiment.
[FIG. 4] FIG. 4(a) is a cross-sectional view of a printed substrate taken along a line A-A of FIG. 3(a), and FIG. 4(b) is a cross-sectional view of a printed substrate taken along a line B-B of FIG. 3(a).
[FIG. 5] FIG. 5(a) to FIG. 5(c) are cross-sectional views illustrating a first method of manufacturing the printed substrate in the first embodiment.
[FIG. 6] FIG. 6(a) to FIG. 6(c) are cross-sectional views illustrating a second method of manufacturing the printed substrate in the first embodiment.
[FIG. 7] FIG. 7 is a cross-sectional view of a strip line on which a simulation is performed.
[FIG. 8] FIG. 8 illustrates a simulation result of an insertion loss of a high frequency signal transmitted through the strip line.
[FIG. 9] FIG. 9 is a cross-sectional view of a cooling structure of the quantum device according to the first embodiment.
[FIG. 10] FIG. 10(a) and FIG. 10(b) are cross-sectional views of a printed substrate in a modification of the first embodiment.
[FIG. 11] FIG. 11(a) to FIG. 11(e) are exploded plan views of a printed substrate in a second embodiment.
[FIG. 12] FIG. 12(a) is a cross-sectional view of a printed substrate taken along a line A-A in FIG. 11(a), and FIG. 12(b) is a cross-sectional view of a printed substrate taken along a line B-B in FIG. 11(a).
[FIG. 13] FIG. 13(a) is a cross-sectional view illustrating a first method of manufacturing the printed substrate in the second embodiment, and FIG. 13(b) is a cross-sectional view illustrating a second method of manufacturing the printed substrate.
[FIG. 14] FIG. 14(a) and FIG. 14(b) are cross-sectional views illustrating a first method of forming a ground wiring having a double-layer structure in the second embodiment, and FIG. 14(c) to FIG. 14(e) are cross-sectional views illustrating a second method of forming the ground wiring.
[FIG. 15] FIG. 15 is a cross-sectional view of a cooling structure of a quantum device according to a second embodiment.
[FIG. 16] FIG. 16(a) and FIG. 16(b) are cross-sectional views of a printed substrate in a modification of the second embodiment.
[FIG. 17] FIG. 17(a) and FIG. 17(b) are cross-sectional views illustrating a first method of forming a ground wiring having a double-layer structure in a modification of the second embodiment, and FIG. 17(c) to FIG. 17(e) are cross-sectional views illustrating a second method of forming the ground wiring.
[FIG. 18] FIG. 18 is a cross-sectional view of a cooling structure of a quantum device according to the modification of the second embodiment.
[FIG. 19] FIG. 19 is a diagram illustrating current density with respect to distance from the surface of a conductor.
[FIG. 20] FIG. 20(a) and FIG. 20(b) are cross-sectional views of a printed substrate in a third embodiment.

[Description of Embodiments]

Hereinafter, embodiments of the present disclosure will be described with reference to the drawings.

[First Embodiment]

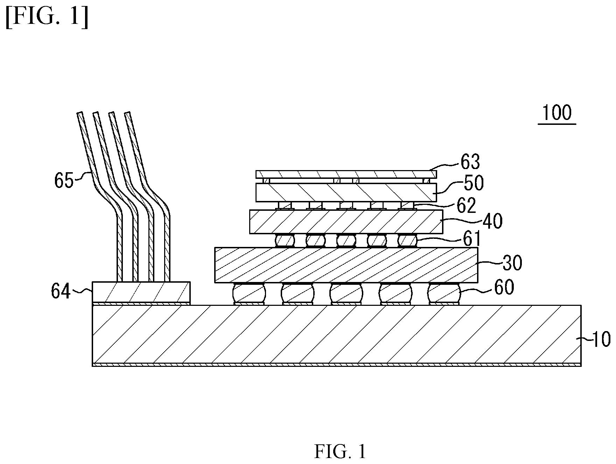

FIG. 1 is a cross-sectional view of a quantum device 100 according to a first embodiment. As illustrated in FIG. 1, the quantum device 100 according to the first embodiment includes a printed substrate 10, a package substrate 30, an interposer 40, and a quantum chip 50. The package substrate 30 is mounted on the printed substrate 10 by bonding materials 60. The interposer 40 is mounted on the package substrate 30 by bonding materials 61. The pitch of the bonding materials 61 is smaller than the pitch of the bonding materials 60. For example, the pitch of the bonding materials 60 is about 1mm, and the pitch of the bonding materials 61 is about 200 $\mu$m. The bonding materials 60 and 61 are solder, and are, for example, Sn-Ag-Cu-based solder or Sn-Cu-based solder.

The quantum chip 50 is mounted on the interposer 40 by bonding materials 62. The bonding material 62 has a bonding temperature lower than the bonding temperatures of the bonding materials 60 and 61, and is, for example, an indium (In) bump or a gold (Au) bump. By using the In bump as the bonding material 62, the temperature when the quantum chip 50 is mounted on the interposer 40 can be kept lower compared to the case of using solder. For example, the bonding temperature is about 200 °C (heating time is about 5 minutes) when the solder is used, whereas the bonding temperature can be kept as low as about 140 °C when the In bump is used. In the case of using ultrasonic Au bonding, the bonding temperature can be kept as low as about 200 °C (heating time is about 3 seconds). The quantum chip 50 includes, for example, a quantum bit having a Josephson junction element.

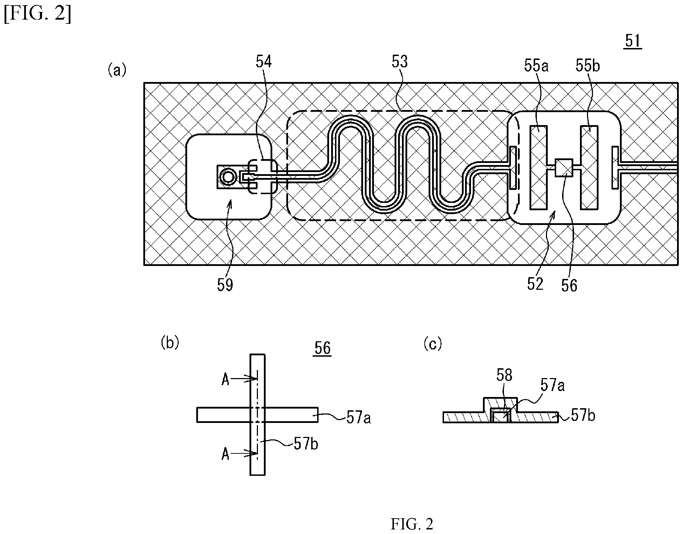

FIG. 2(a) is a plan view of a quantum bit 51 included in the quantum chip 50 in the first embodiment, FIG. 2(b) is a plan view of a Josephson junction element 56, and FIG. 2(c) is a cross-sectional view taken along a line A-A in FIG. 2(b). In FIG. 2(a), the conductive film is hatched for the sake of clarity. As illustrated in FIG. 2(a) to FIG. 2(c), the quantum bit 51 includes a quantum bit element 52, a resonator 53, and a filter 54. The quantum bit element 52 includes the Josephson junction element 56 connected between an electrode 55a and an electrode 55b. In the Josephson junction element 56, a superconducting film 57a and a superconducting film 57b overlap each other with an insulating film 58 interposed therebetween. The superconducting films 57a and 57b are, for example, aluminum (Al) films. The insulating film 58 is, for example, an aluminum oxide ($Al_2O_3$) film. The superconducting films 57a and 57b are formed of a superconducting material to which no magnetic materials are added. The Josephson junction element 56 is connected between the electrodes 55a and 55b by connecting the superconducting film 57a to the electrode 55a and connecting the superconducting film 57b to the electrode 55b. The quantum bit element 52 includes a transmon including the Josephson junction element 56 and a capacitor including the electrodes 55a and 55b connected in parallel to the Josephson junction element 56. The resonator 53 includes, for example, a coplanar line having a meander structure, and one end of the resonator 53 is electrostatically coupled to the quantum bit element 52. The other end of the resonator 53 is connected to a readout unit 59 via the filter 54.

In FIG. 1, when the temperature at the time of mounting the quantum chip 50 on the interposer 40 becomes high, the thickness of the insulating film 58 of the Josephson junction element 56 may change, and the characteristics of the quantum bit element 52 change. Therefore, after the package substrate 30 is mounted on the printed substrate 10 by the bonding materials 60 and the interposer 40 is mounted on the package substrate 30 by the bonding materials 61, the quantum chip 50 is mounted on the interposer 40 by the bonding materials 62 formed of In bumps, Au bumps, or the like. Accordingly, it is possible to avoid a temperature rise of the quantum chip 50 and suppress a change in characteristics of the quantum bit element 52. As illustrated in FIG. 1, a cover chip 63 may be provided to cover the quantum chip 50.

Cables 65 are connected to the printed substrate 10 via a connector 64. One ends of the cables 65 are connected to the connector 64, and the other ends are connected to an external device such as a high frequency generation device or a high frequency reception device. High frequency (for example, 1GHz to 10GHz) electrical signals transmitted and received between the quantum chip 50 and the external device are transmitted through the cables 65, the connector 64, the printed substrate 10, the bonding materials 60, the package substrate 30, the bonding materials 61, the interposer 40, and the bonding materials 62.

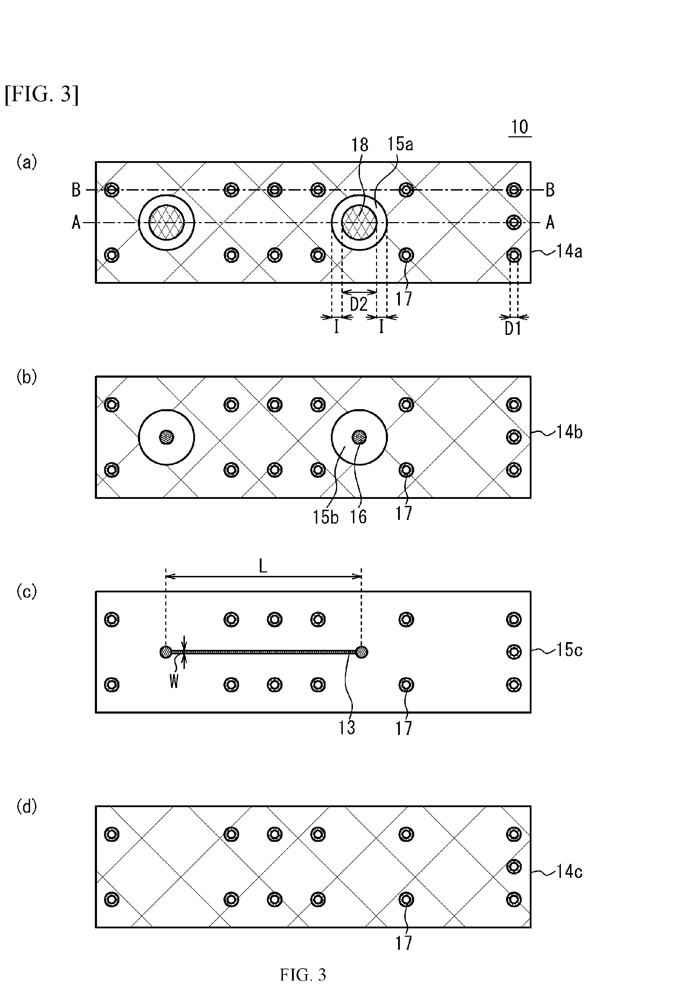

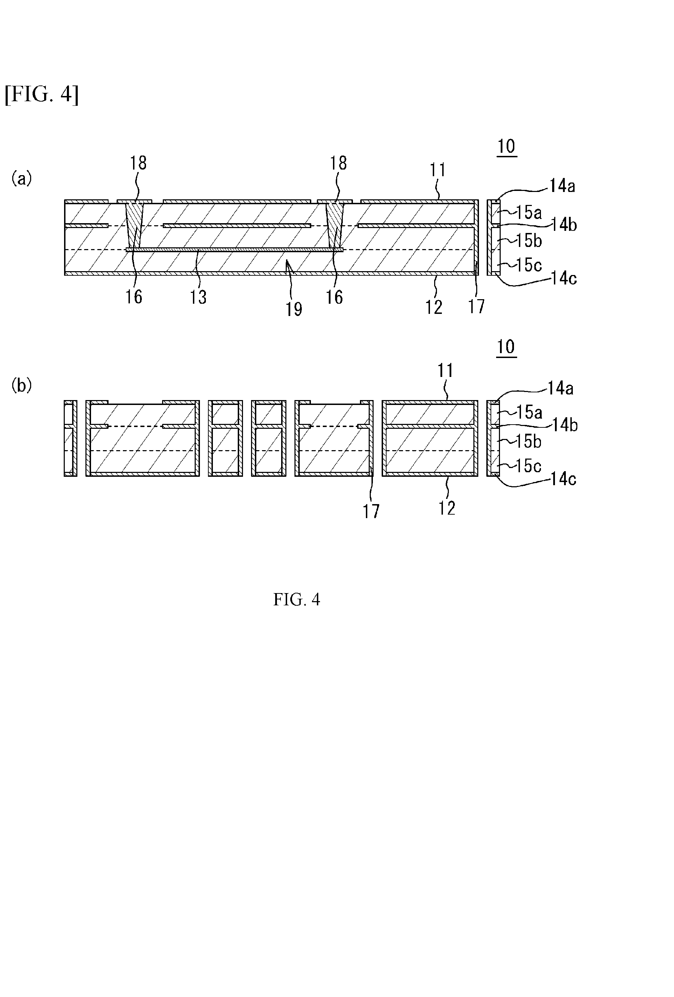

FIG. 3(a) to FIG. 3(d) are exploded plan views of the printed substrate 10 in the first embodiment. FIG. 4(a) is a cross-sectional view of the printed substrate 10 taken along a line A-A in FIG. 3(a), and FIG. 4(b) is a cross-sectional view of the printed substrate 10 taken along a line B-B in FIG. 3(a). FIG. 3(a) to FIG. 3(d) are plan views of the respective layers as viewed from above. In FIGs. 3(a) to 3(d), a signal wiring 13, ground wirings 14a, 14b, and 14c, signal vias 16, ground vias 17, and lands 18 are hatched for the sake of clarity of the drawings.

As illustrated in FIG. 3(a) to FIG. 3(d), FIG. 4(a), and FIG. 4(b), the printed substrate 10 includes the signal wiring 13, the plurality of ground wirings 14a, 14b, and 14c, and a plurality of insulating layers 15a, 15b, and 15c. The ground wiring 14a (third wiring) is provided so as to be exposed on an upper surface 11 (first surface) of the printed substrate 10. The ground wiring 14c (second wiring) is provided to be exposed on a lower surface 12 (second surface) of the printed substrate 10. The signal wiring 13 (first wiring) and the ground wiring 14b (fourth wiring) are provided inside the printed substrate 10. At least a part of the signal wiring 13 overlaps both the ground wirings 14a and 14c in plan view. The insulating layer 15a is a layer located between the ground wiring 14a and the ground wiring 14b. The insulating layer 15b is a layer located between the ground wiring 14b and the signal wiring 13. The insulating layer 15c is a layer located between the signal wiring 13 and the ground wiring 14c.

The signal wiring 13 has an upper surface facing the ground wiring 14b with the insulating layer 15b interposed therebetween, and a lower surface facing the ground wiring 14c with the insulating layer 15c interposed therebetween, and is interposed between the ground wiring 14b and the ground wiring 14c. Thus, the signal wiring 13 and the ground wirings 14b and 14c form a strip line 19.

The printed substrate 10 further includes the signal vias 16 connected to the signal wiring 13, the ground vias 17 connected to the ground wirings 14a, 14b, and 14c, and the lands 18 connected to the signal vias 16. The lands 18 are provided to be exposed on the upper surface 11 of the printed substrate 10. The signal vias 16 are provided on the printed substrate 10 from the lands 18 to the signal wiring 13. The ground vias 17 are provided to penetrate from the upper surface 11 to the lower surface 12 of the printed substrate 10.

The signal wiring 13 is formed of a superconducting material. The superconducting material is a material that is in a superconducting state at a cryogenic temperature (for example, several tens of mK). Examples of the superconducting material used for the signal wiring 13 include aluminum (Al), titanium nitride (TiN), and niobium (Nb). No magnetic material is added to the superconducting material of the signal wiring 13. The ground wirings 14a, 14b, and 14c are formed of a normal conducting material. The normal conducting material is a material that does not become a superconducting state in a temperature range of the cryogenic temperature (for example, several tens of mK). Examples of the normal conducting material used for the ground wirings 14a, 14b, and 14c include copper (Cu) and silver (Ag).

The insulating layers 15a, 15b, and 15c are formed of, for example, epoxy resins, phenolic resins, or glass epoxy resins. The signal vias 16 and the lands 18 are formed of a superconducting material (for example, Al, TiN, or Nb) or a normal conducting material (for example, Cu or Ag). The ground vias 17 are formed of the normal conducting material (for example, Cu or Ag).

A width W of the signal wiring 13 is several tens of micrometers to one hundred and several tens of micrometers, for example, 50 $\mu$m to 150 $\mu$m. A length L of the signal wiring 13 is several centimeters to several tens of centimeters, for example, 5 cm to 20 cm. The thickness of the signal wiring 13 and the ground wirings 14a, 14b, and 14c is several tens of micrometers, for example, 10 $\mu$m to 50 $\mu$m. The thickness of the insulating layers 15a, 15b, and 15c is several tens of micrometers to one hundred and several tens of micrometers, for example, 80 $\mu$m to 120 $\mu$m. The thickness of the conductive material of the inner walls of the ground vias 17 is, for example, about 25 $\mu$m, and diameters D1 of the through holes inside the ground vias 17 are, for example, about 100 $\mu$m. The land 18 has a diameter D2 of, for example, about 400 $\mu$m. An interval I between the land 18 and the ground wiring 14a is, for example, about 100 $\mu$m.

[Method for Manufacturing Printed Substrate]

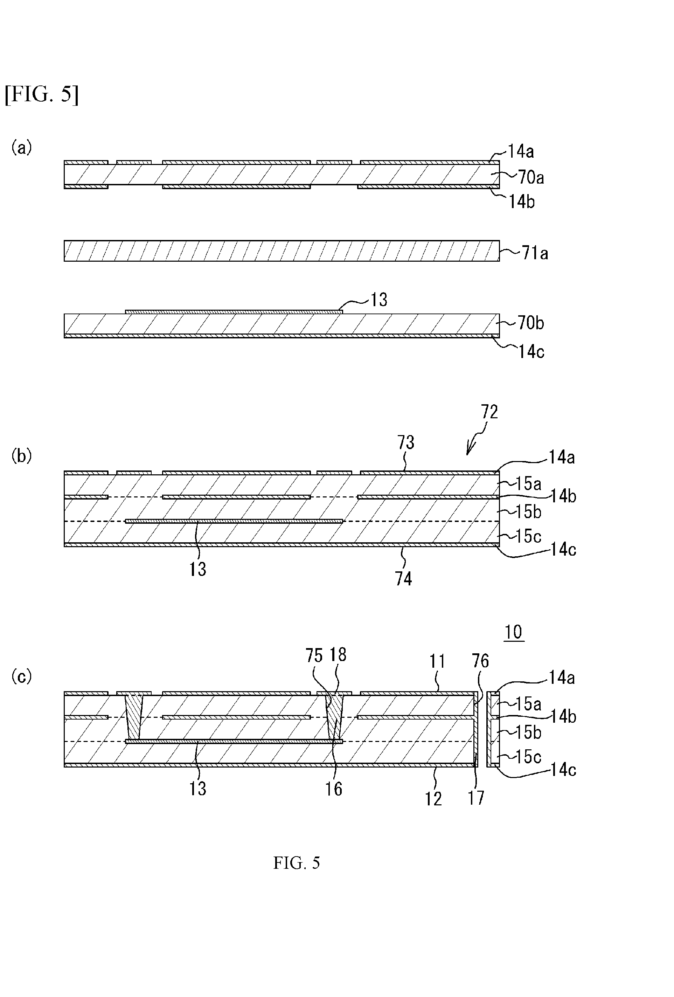

FIG. 5(a) to FIG. 5(c) are cross-sectional views illustrating a first method of manufacturing the printed substrate 10 in the first embodiment. As illustrated in FIG. 5(a), a cured insulating layer 70a having the ground wiring 14a formed on the upper surface thereof and the ground wiring 14b formed on the lower surface thereof is prepared. Similarly, a cured insulating layer 70b having the signal wiring 13 formed on the upper surface thereof and the ground wiring 14c formed on the lower surface thereof is prepared. The insulating layers 70a and 70b are formed by curing a thermosetting resin (e.g., glass epoxy resin). The ground wirings 14a, 14b, and 14c are formed by, for example, attaching conductive foils (for example, Cu foils) of the normal conducting material to the surfaces of the insulating layers 70a and 70b and patterning the conductive foils. The signal wiring 13 is formed by, for example, attaching conductive foils (for example, an Al foils) of the superconducting material to the surfaces of the insulating layers 70a and 70b and patterning the conductive foils. An insulating layer 71a in a semi-cured state is arranged so as to be interposed between the insulating layer 70a and the insulating layer 70b. The insulating layer 71a is a semi-cured thermosetting resin (e.g., glass epoxy resin) and serves as an adhesive. The semi-cured state is a state in which curing is stopped halfway. The cured resin is also referred to as a core, and the semi-cured resin is also referred to as a prepreg. The components of the cured resin and the semi-cured resin may be the same as each other.

The insulating layer 70a, the insulating layer 71a, and the insulating layer 70b are stacked so as to interpose the insulating layer 71a, and the insulating layer 71a is cured by applying pressure and temperature thereto from the stacking direction. As a result, as illustrated in FIG. 5(b), a multilayer body 72 is formed in which the insulating layers 15a, 15b, and 15c are provided between the signal wiring 13 and the ground wirings 14a, 14b, and 14c. In the multilayer body 72, the ground wiring 14a is exposed on an upper surface 73, and the ground wiring 14c is exposed on a lower surface 74. In the stacking direction of the multilayer body 72, the signal wiring 13 faces the ground wiring 14c with the insulating layer 15c interposed therebetween. The ground wiring 14b faces the signal wiring 13 with the insulating layer 15b interposed therebetween, and the signal wiring 13 is interposed between the ground wiring 14b and the ground wiring 14c.

As illustrated in FIG. 5(c), holes 75 reaching the signal wiring 13 are formed by, for example, laser processing, and a superconducting film or a normal conducting film is embedded in the holes 75 by, for example, a plating method to form the signal vias 16 and the lands 18. For example, through holes 76 penetrating the multilayer body 72 from the upper surface 73 to the lower surface 74 are formed by drilling processing, and a normal conductive film is formed on the inner surface of the through hole 76 by, for example, a plating method to form the ground vias 17. In this way, the printed substrate 10 is formed.

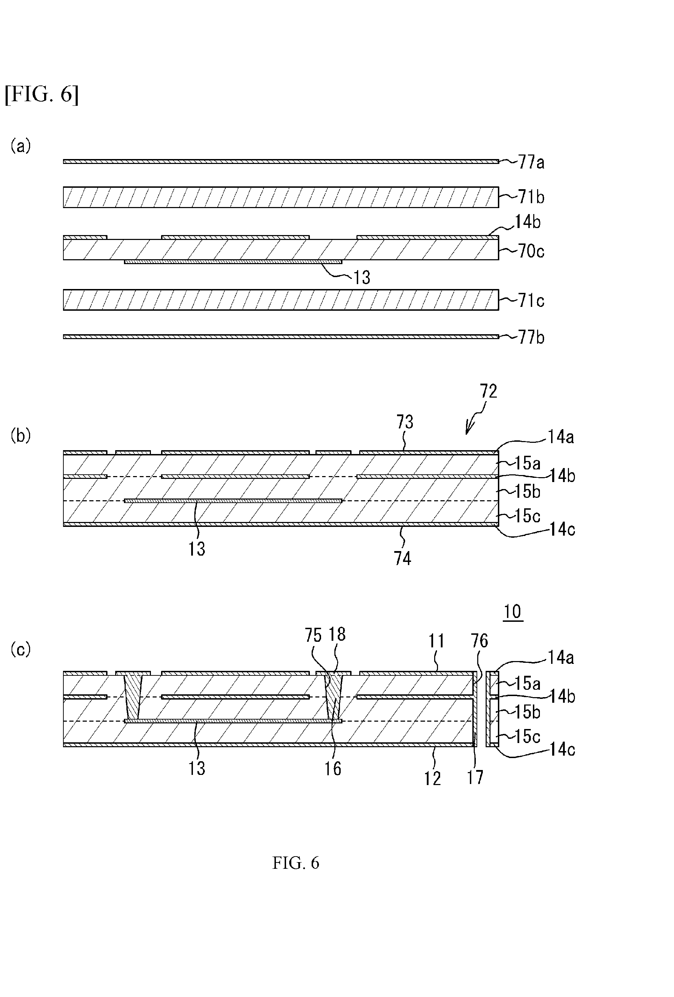

FIG. 6(a) to FIG. 6(c) are cross-sectional views illustrating a second method of manufacturing the printed substrate 10 in the first embodiment. As illustrated in FIG. 6(a), an insulating layer 70c having the ground wiring 14b formed on the upper surface thereof and the signal wiring 13 formed on the lower surface thereof is formed. The insulating layer 70c, the ground wiring 14b, and the signal wiring 13 are formed by the same method as the first manufacturing method. Insulating layers 70c and 71c are disposed on both sides of an insulating layer 71b, and conductive foils 77a and 77b (for example, Cu foils) made of the normal conducting material are disposed on the outer sides of the insulating layers 71b and 71c. The insulating layers 71b and 71c are formed by semi-curing a thermosetting resin (for example, a glass epoxy resin), and serve as an adhesive, as in the first manufacturing method.

The conductive foils 77a and 77b, the insulating layers 71b and 71c and the insulating layers 70c are stacked, and the insulating layers 71b and 71c are cured by applying pressure and temperature from the stacking direction. Thereafter, the conductive foils 77a and 77b are patterned. As a result, as illustrated in FIG. 6(b), the multilayer body 72 is formed in which the insulating layers 15a, 15b, and 15c are provided between the signal wiring 13 and the ground wirings 14a, 14b, and 14c. In the multilayer body 72, the ground wiring 14a is exposed on the upper surface 73, and the ground wiring 14c is exposed on the lower surface 74. In the stacking direction of the multilayer body 72, the signal wiring 13 faces the ground wiring 14c with the insulating layer 15c interposed therebetween. The ground wiring 14b faces the signal wiring 13 with the insulating layer 15b interposed therebetween, and the signal wiring 13 is interposed between the ground wiring 14b and the ground wiring 14c.

As illustrated in FIG. 6(c), the signal vias 16, the ground vias 17, and the lands 18 are formed by the same method as the method described with reference to FIG. 5(c). In this way, the printed substrate 10 is formed.

[Simulation]

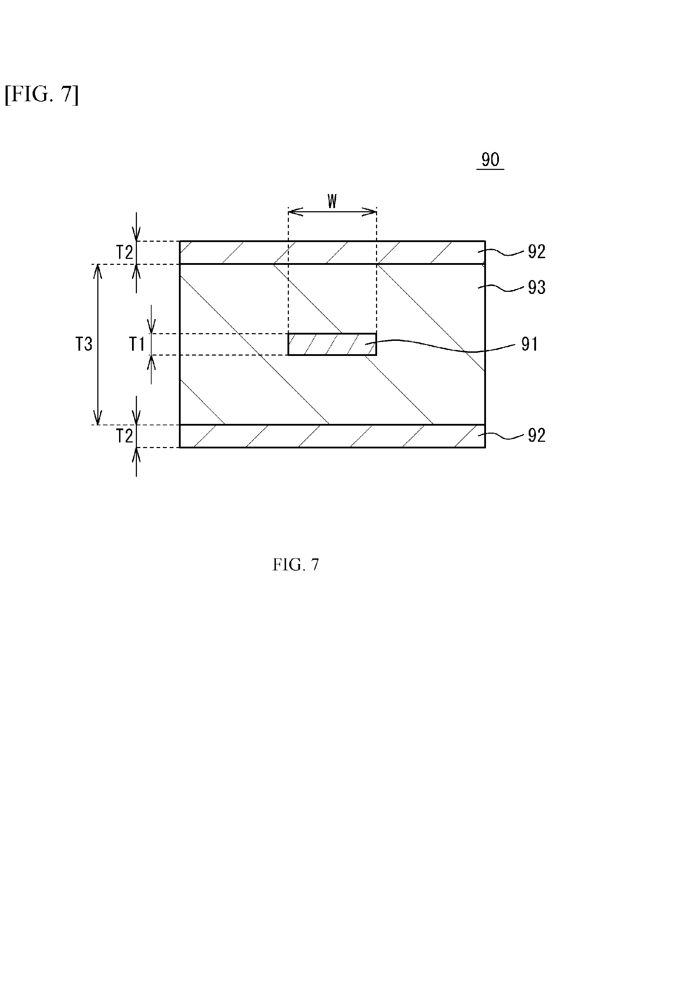

FIG. 7 is a cross-sectional view of a strip line 90 on which a simulation was performed. As illustrated in FIG. 7, the strip line 90 includes ground wirings 92 provided on the upper and lower surfaces of a dielectric layer 93, and a signal wiring 91 provided inside the dielectric layer 93. An insertion loss S21 of the strip line 90 was simulated. The simulation conditions are as follows.

Signal wiring 91: aluminum (Al) layer or copper (Cu) layer having a thickness T1 of 30 $\mu$m, a width W of 100 $\mu$m, and a length of 10 cm
Ground wiring 92: aluminum (Al) layer or copper (Cu) layer having a thickness T2 of 30 $\mu$m
Dielectric layer 93: thickness T3 of 100 $\mu$m, dielectric constant of 3.3, dielectric loss tangent of 0.004
Temperature: 10 mK

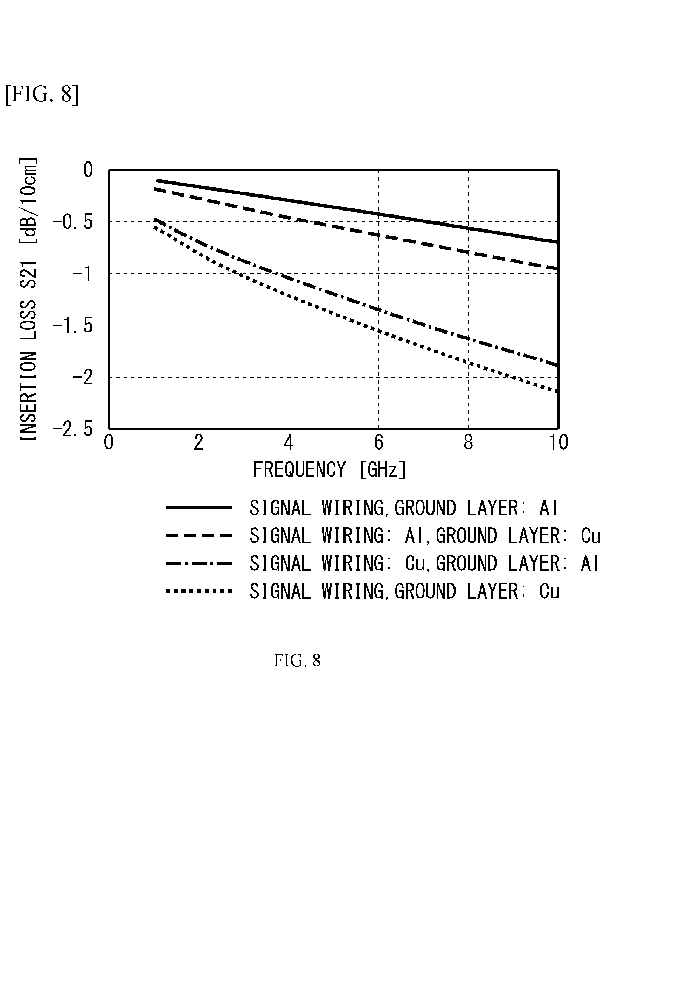

FIG. 8 illustrates a simulation result of the insertion loss S21 of the high frequency signal transmitted through the strip line 90. In FIG. 8, a horizontal axis represents frequency [GHz], and a vertical axis represents insertion loss S21 [dB/10cm]. A simulation result in the case where both the signal wiring 91 and the ground wiring 92 are Al layers is indicated by a solid line. A simulation result in the case where the signal wiring 91 is an Al layer and the ground wirings 92 is a Cu layer is indicated by a broken line. A simulation result in the case where the signal wiring 91 is a Cu layer and the ground wiring 92 is an Al layer is indicated by a one dot chain line. A simulation result in the case where both the signal wiring 91 and the ground wiring 92 are Cu layers is indicated by a dotted line.

As illustrated in FIG. 8, in the case where both the signal wiring 91 and the ground wiring 92 are Al layers (solid line), the insertion loss S21 is greatly reduced as compared with the case where both the signal wiring 91 and the ground wiring 92 are Cu layers (dotted line). This is considered to be because Cu is the normal conducting material, whereas Al is the superconducting material, and thus Al is in a superconducting state at a temperature of 10 mK, and the electric resistance is reduced. In the case where the signal wiring 91 was an Al layer and the ground wiring 92 was a Cu layer (broken line), the insertion loss S21 was deteriorated as compared with the case where both the signal wiring 91 and the ground wiring 92 were Al layers (solid line), but was reduced as compared with the case where both the signal wiring 91 and the ground wiring 92 were Cu layers (dotted line). Even when the signal wiring 91 is a Cu layer and the ground wiring 92 is an Al layer (one dot chain line), the insertion loss S21 is reduced as compared with the case where both the signal wiring 91 and the ground wiring 92 are Cu layers (dotted line). From the simulation results, it is understood that the reduction of the insertion loss S21 is highly effective when both the signal wiring 91 and the ground wiring 92 are made of the superconducting material, but a sufficient effect can be obtained even when only the signal wiring 91 is made of the superconducting material.

Here, it is known that the superconducting material has a very high thermal resistance at the cryogenic temperature and is completely adiabatic at absolute zero. On the other hand, a quantum chip is cooled to the cryogenic temperature so as to operate in the superconducting state.

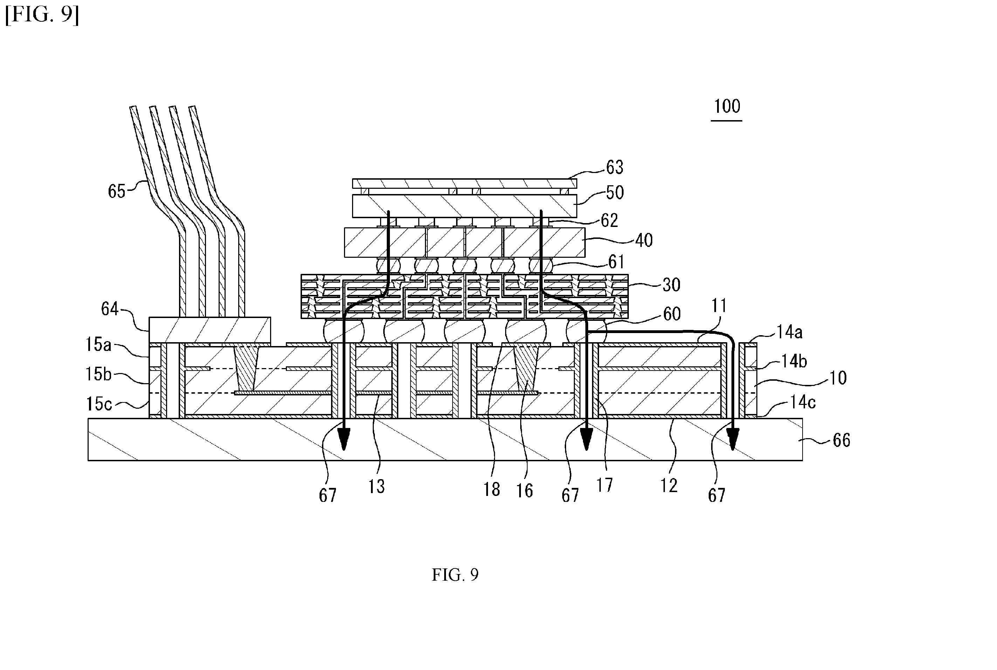

FIG. 9 is a cross-sectional view illustrating a cooling structure of the quantum device 100 according to the first embodiment. In FIG. 9, for convenience of description of cooling, the printed substrate 10 is illustrated as a combination of FIG. 4(a) and FIG. 4(b). As illustrated in FIG. 9, the printed substrate 10 is disposed on the upper surface of a cooling plate 66. Thus, the ground wiring 14c exposed on the lower surface 12 of the printed substrate 10 is brought into contact with the cooling plate 66. The cooling plate 66 is, for example, a copper plate having a thickness of about 1 cm. The cooling plate 66 is cooled by a refrigerator (not illustrated) capable of cooling the cooling plate 66 to, for example, about 10 mK. Therefore, when the printed substrate 10 is disposed on the cooling plate 66, heat transfer occurs between the quantum chip 50 and the cooling plate 66 through the ground wiring 14a, the ground vias 17, and the ground wiring 14c of the printed substrate 10 as indicated by arrows 67. This makes it possible to cool the quantum chip 50 to the cryogenic temperature (e.g., several tens mK), and to operate the quantum chip 50 in the superconducting state.

Here, in order to reduce the loss of the high frequency signal, it is conceivable to form all of the signal wiring 13, the ground wirings 14a, 14b, and 14c, the signal vias 16, the ground vias 17, and the lands 18 of the printed substrate 10 with the superconducting material (for example, Al). However, since the printed substrate 10 is also cooled to the cryogenic temperature by the cooling plate 66, the signal wiring 13 and the ground wirings 14a, 14b, 14c, and the like are also cooled to the cryogenic temperature. When the ground wirings 14a, 14b, 14c and the ground vias 17 are formed of the superconducting material, the ground wirings 14a, 14b, 14c and the ground vias 17 have high heat resistance when they are cooled to the cryogenic temperature. Therefore, the heat transfer as indicated by the arrows 67 is less likely to occur, and the quantum chip 50 may not be cooled to the cryogenic temperature.

Therefore, in the first embodiment, the signal wiring 13 is formed of the superconducting material, but the ground wirings 14a, 14b, and 14c and the ground via 17 are formed of the normal conducting material. Thus, even when the ground wirings 14a, 14b, and 14c and the ground vias 17 are cooled to the cryogenic temperature, the heat resistance is suppressed to be low as compared with the case where they are formed of the superconducting material. Therefore, the quantum chip 50 can be cooled to the cryogenic temperature. Further, by forming the signal wiring 13 with the superconducting material, the signal wiring 13 is cooled to the cryogenic temperature and the electrical resistance thereof becomes small, and therefore, as illustrated in FIG. 8, the loss of the high frequency signal can be reduced.

[Modifications]

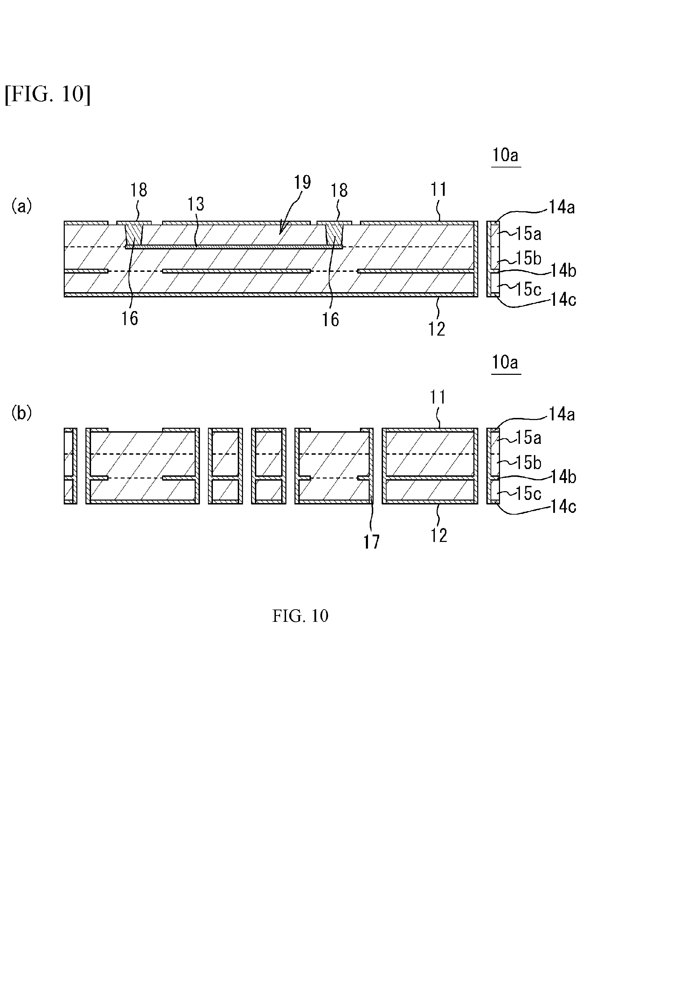

FIG. 10(a) and FIG. 10(b) are cross-sectional views of a printed substrate 10a in a modification of the first embodiment. As illustrated in FIG. 10(a) and FIG. 10(b), in the printed substrate 10a in the modification of the first embodiment, the ground wiring 14c, the insulating layer 15c, the ground wiring 14b, the insulating layer 15b, the signal wiring 13, the insulating layer 15a, and the ground wiring 14a are stacked in this order from the lower surface 12 toward the upper surface 11. Therefore, the upper surface of the signal wiring 13 faces the ground wiring 14a with the insulating layer 15a interposed therebetween, the lower surface of the signal wiring 13 faces the ground wiring 14b with the insulating layer 15b interposed therebetween, and the signal wiring 13 is interposed between the ground wiring 14a and the ground wiring 14b. Therefore, the signal wiring 13 and the ground wirings 14a and 14b form the strip line 19. The other configurations are the same as those of the first embodiment, and thus the description thereof will be omitted.

As described above, in the first embodiment and the modifications thereof, the signal wiring 13 is formed of the superconducting material. This can reduce the loss of the high frequency signal. As illustrated in FIGs. 4(b) and 10(b), the ground wiring 14a exposed on the upper surface 11 of the printed substrates 10 and 10a and the ground wiring 14c exposed on the lower surface 12 of the printed substrate 10 are connected to each other through the ground vias 17. The ground wirings 14a and 14c and the ground vias 17 are formed of the normal conducting material. As described with reference to FIG. 9, even when the printed substrates 10 and 10a are cooled to the cryogenic temperature in order to cool the quantum chip 50 provided on the printed substrates 10 and 10a to the cryogenic temperature, the heat transfer between the quantum chip 50 and the cooling plate 66 is maintained. Therefore, the quantum chip 50 can be cooled to the cryogenic temperature. As described above, the first embodiment and the modifications thereof can reduce the loss of the high frequency signal while ensuring the coolability.

In the first embodiment and the modifications thereof, as illustrated in FIG. 4(a) and FIG. 10(a), the signal wiring 13 faces one of the ground wirings 14a and 14c and the ground wiring 14b and is interposed therebetween. Thus, the strip line 19 that transmits the high frequency signal to the quantum chip 50 is formed. By using either the ground wiring 14a or the ground wiring 14c as one of the ground wirings forming the strip line 19, the printed substrates 10 and 10a can be downsized.

In the first embodiment and the modifications thereof, the signal vias 16 connected to the signal wiring 13 are formed of the superconducting material or the normal conducting material. When the signal vias 16 are formed of the superconducting material, the loss of the high frequency signal can be further reduced. When the signal vias 16 are formed of the normal conducting material, the signal vias 16 can be formed simultaneously with the ground vias 17, and thus the manufacturing cost can be reduced.

In the method of manufacturing the first embodiment and the modifications thereof, as illustrated in FIG. 5(b) and FIG. 6(b), the multilayer body 72 is formed in which the signal wiring 13 including the superconducting material and the ground wirings 14a, 14b, and 14c including the normal conducting material are stacked with the insulating layers 15a, 15b, and 15c interposed therebetween. The ground wiring 14a is exposed on the upper surface 73 of the multilayer body 72, and the ground wiring 14c is exposed on the lower surface 74 of the multilayer body 72. As illustrated in FIG. 5(c) and FIG. 6(c), the ground vias 17 including the normal conducting material and connecting the ground wiring 14a and the ground wiring 14c are formed in the multilayer body 72. Accordingly, the printed substrates 10 and 10a that can secure the coolability even when cooled to the cryogenic temperature, and can reduce the loss of the high frequency signal are obtained.

In the first embodiment, as illustrated in FIGs. 5(b) and 6(b), the multilayer body 72 is formed in which the signal wiring 13 is interposed between the ground wiring 14c and the ground wiring 14b so as to face the ground wiring 14c and the ground wiring 14b. In the modification of the first embodiment, as illustrated in FIG. 10(a), the multilayer body 72 is formed in which the signal wiring 13 is interposed between the ground wiring 14a and the ground wiring 14b so as to face the ground wiring 14a and the ground wiring 14b. Thus, the strip line 19 for transmitting the high frequency signal is formed.

In the first embodiment, as illustrated in FIG. 5(a), the insulating layer 71a is interposed between the insulating layer 70a on which the ground wiring 14a is formed and the insulating layer 70b on which the ground wiring 14c and the signal wiring 13 are formed. In the modification of the first embodiment, as is clear from FIG. 10(a), the insulating layer 71a is interposed between the insulating layer 70a on which the ground wiring 14a and the signal wiring 13 are formed, and the insulating layer 70b on which the ground wiring 14c is formed. Thereafter, as illustrated in FIG. 5(b), the insulating layer 71a is cured to form the multilayer body 72. This facilitates formation of the printed substrates 10 and 10a.

In the first embodiment and the modifications thereof, as illustrated in FIG. 6(a), the insulating layers 71b and 71c, and the insulating layer 70c having the signal wiring 13 formed thereon are interposed between the conductive foils 77a and 77b, and the insulating layer 70c is interposed between the insulating layers 71b and 71c. Thereafter, as illustrated in FIG. 6(b), the insulating layers 71b and 71c are cured, and then the conductive foils 77a and 77b are processed to form the ground wirings 14a and 14c, thereby forming the multilayer body 72. This facilitates formation of the printed substrates 10 and 10a.

[Second Embodiment]

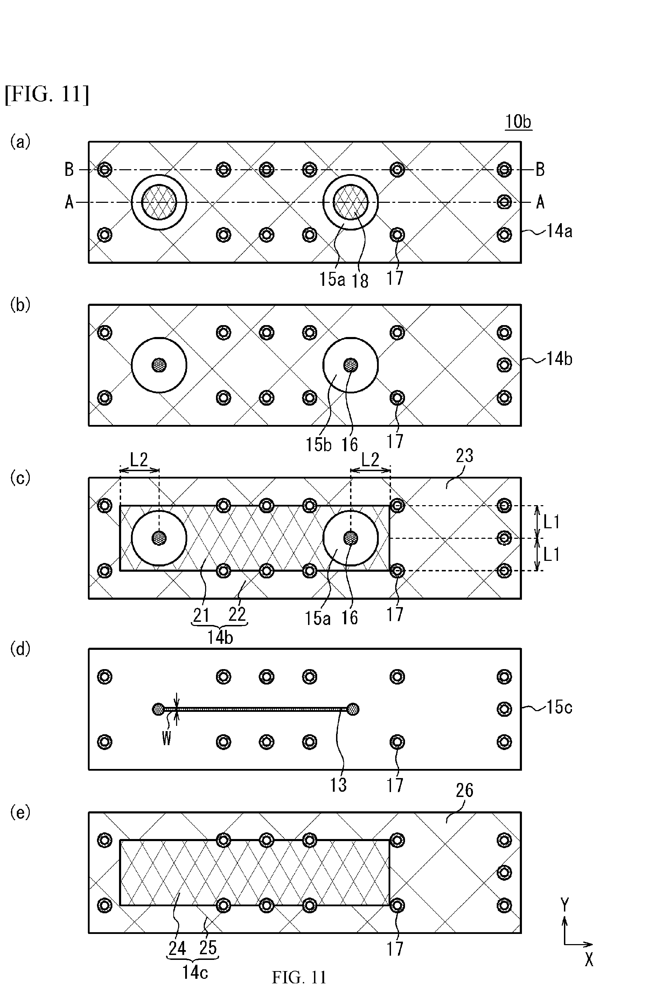

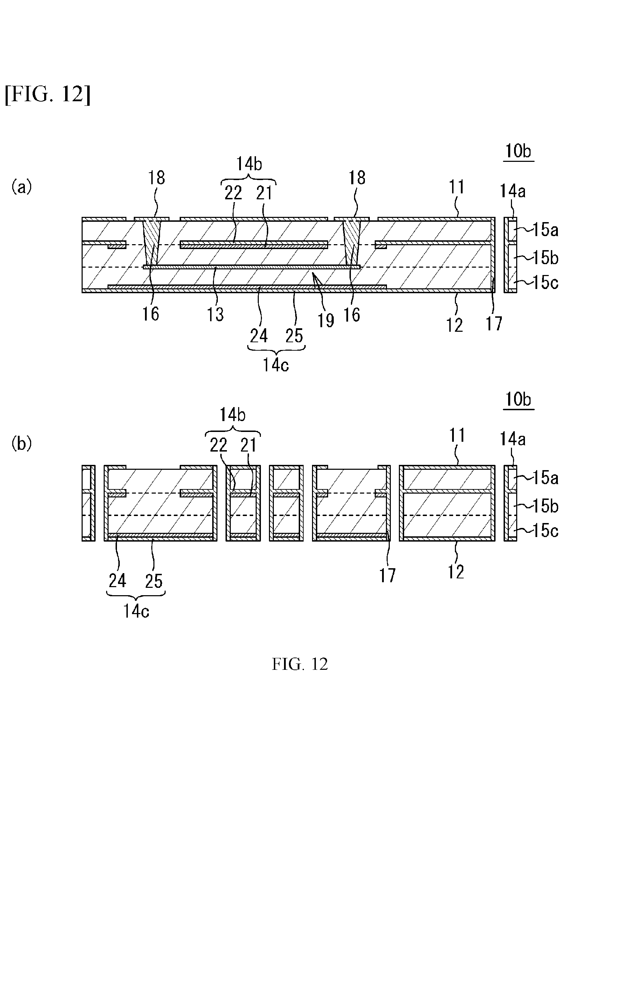

FIG. 11(a) to FIG. 11(e) are exploded plan views of a printed substrate 10b in a second embodiment. FIG. 12(a) is a cross-sectional view of the printed substrate 10b taken along a line A-A in FIG. 11(a), and FIG. 12(b) is a cross-sectional view of the printed substrate 10b taken along a line B-B in FIG. 11(a). FIG. 11(a), FIG. 11(b), FIG. 11(d), and FIG. 11(e) are plan views of the respective layers as viewed from above, and FIG. 11(c) is a plan view of the ground wiring 14b as viewed from below. In FIG. 11(a) to FIG. 11(e), the signal wiring 13, the ground wirings 14a, 14b, and 14c, the signal vias 16, the ground vias 17, and the lands 18 are hatched for the sake of clarity of the drawings.

As illustrated in FIGs. 11(a) to 11(e), 12(a), and 12(b), in the printed substrate 10b of the second embodiment, the ground wiring 14b includes a first layer 21 and a second layer 22. The first layer 21 is provided on a surface 23 of the second layer 22 on the signal wiring 13 side. The first layer 21 is formed of the superconducting material, for example, Al. The second layer 22 is formed of the normal conducting material, for example, Cu.

The first layer 21 is not provided on the entire surface 23 of the second layer 22, but is provided on a part of the surface 23 with an area larger than that of the signal wiring 13 so as to overlap the signal wiring 13 in plan view. The first layer 21 has, for example, a rectangular shape that is point-symmetrical with respect to a point overlapping the center point of the signal wiring 13 in plan view. A length L1 from a line overlapping the center line of the signal wiring 13 in the width direction (Y direction) of the signal wiring 13 to the end of the first layer 21 in the Y direction is three times or more a width W of the signal wiring 13, and may be five times or more the width W. For example, when the width W of the signal wiring 13 are 80 $\mu$m, the length L1 is 500 $\mu$m. A length L2 from a position overlapping the tip portion of the signal wiring 13 in the length direction (X direction) of the signal wiring 13 to the end of the first layer 21 in the X direction is also three times or more the width W of the signal wiring 13, and may be five times or more the width W. That is, the first layer 21 is provided on the surface 23 of the second layer 22 over a range of three times or more the width W of the signal wiring 13 from the portion overlapping the signal wiring 13, and may be provided over a range of five times or more the width W of the signal wiring 13.

The ground wiring 14c also includes a first layer 24 and a second layer 25, similarly to the ground wiring 14b. The first layer 24 is provided on a surface 26 of the second layer 25 on the signal wiring 13 side. The first layer 24 is formed of the superconducting material, for example, Al. The second layer 25 is formed of the normal conducting material, for example, Cu.

The first layer 24 is not provided on the entire surface 26 of the second layer 25, but is provided on a part of the surface 26 with an area larger than that of the signal wiring 13 so as to overlap the signal wiring 13 in plan view. The first layer 24 has a rectangular shape that is point-symmetrical with respect to a point overlapping the center point of the signal wiring 13 in plan view, for example, as with the first layer 21 of the ground wiring 14b. The first layer 24 is provided on the surface 26 of the second layer 25 over a range of three times or more the width W of the signal line from the position overlapping the signal wiring 13, or may be provided over a range of five times or more the width W of the signal wiring 13, as with the first layer 21 of the ground wiring 14b.

The ground vias 17 are connected to the ground wirings 14a, 14b, and 14c, and are connected to at least the second layers 22 and 25 in the ground wirings 14b and 14c. The other configurations of the quantum device according to the second embodiment are the same as those of the quantum device 100 according to the first embodiment, and thus the illustration and description thereof are omitted.

[Method for Manufacturing Printed substrate]

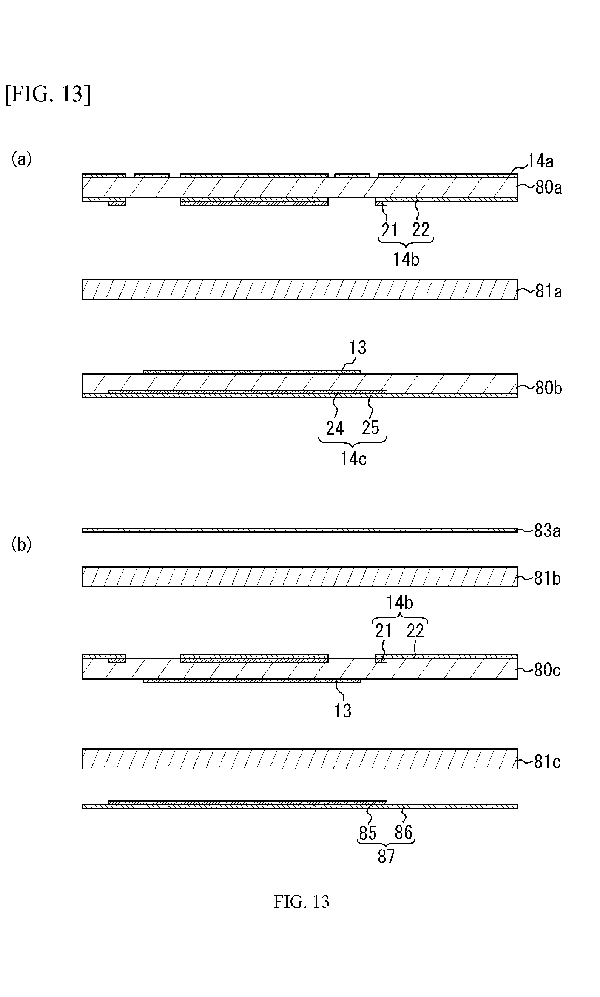

FIG. 13(a) is a cross-sectional view illustrating a first method of manufacturing the printed substrate 10b according to the second embodiment. As illustrated in FIG. 13(a), an insulating layer 80a having the ground wiring 14a formed on the upper surface thereof and the ground wiring 14b including the first layer 21 and the second layer 22 formed on the lower surface thereof is prepared. In addition, an insulating layer 80b having the signal wiring 13 formed on the upper surface thereof and the ground wiring 14c including the first layer 24 and the second layer 25 formed on the lower surface thereof is prepared. Then, an insulating layer 81a is disposed between the insulating layer 80a and the insulating layer 80b. Thereafter, the same steps as those of FIGs. 5(b) and 5(c) of the first embodiment are performed. Thus, the printed substrate 10b according to the second embodiment is formed.

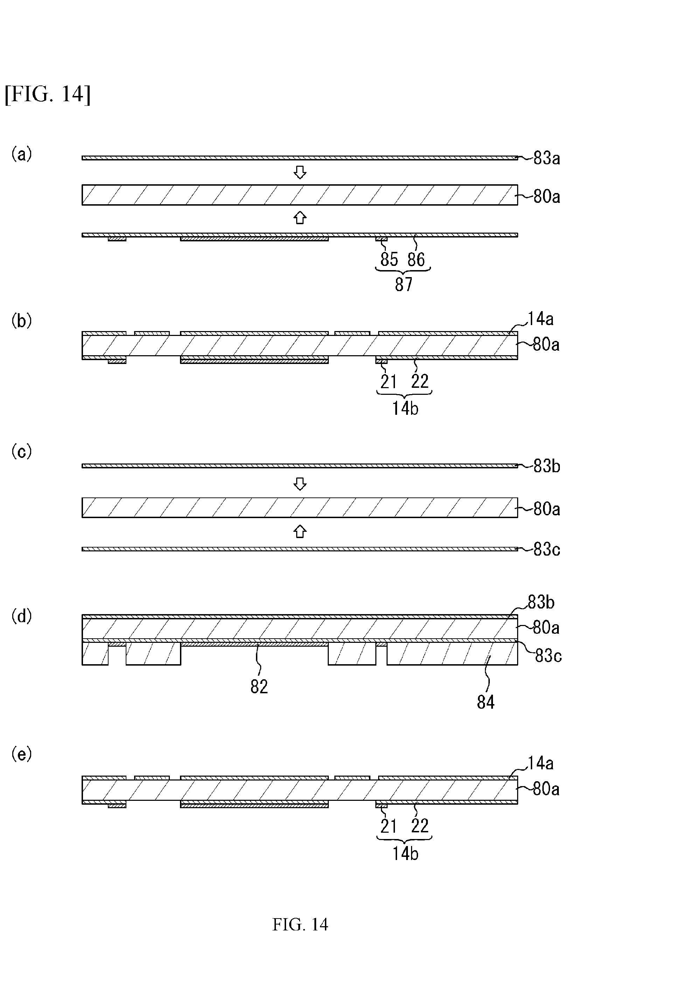

Here, a method of forming the ground wirings 14b and 14c having a double-layer structure will be described. Since the ground wirings 14b and 14c are formed by the same method, the ground wiring 14b will be described as an example. FIGs. 14(a) and 14(b) are cross-sectional views illustrating a first method of forming the ground wiring 14b having the double-layer structure in the second embodiment, and FIG. 14(c) to 14(e) are cross-sectional views illustrating a second method of forming the ground wiring 14b having the double-layer structure in the second embodiment.

In the first forming method, first, as illustrated in FIG. 14(a), a conductive film 83a (for example, a conductive film (Cu film)) of the normal conducting material is attached to the upper surface of the insulating layer 80a. A conductive film 87 in which a film 85 (for example, an Al film) made of the superconducting material and a film 86 (for example, a Cu film) made of the normal conducting material are integrated is attached to the lower surface of the insulating layer 80a. The conductive film 87 is formed by forming the film 85 on the surface of the film 86, which is a conductive foil, by a plating method, for example. Next, as illustrated in FIG. 14(b), the ground wiring 14a is formed by patterning the conductive film 83a on the upper surface of the insulating layer 80a. The ground wiring 14b having the double-layer structure of the first layer 21 and the second layer 22 is formed by patterning the conductive film 87 on the lower surface of the insulating layer 80a.

In the second forming method, first, as illustrated in FIG. 14(c), conductive films 83b and 83c (for example, conductive foils (Cu foils)) of the normal conducting material are attached to the upper surface and the lower surface of the insulating layer 80a. Next, as illustrated in FIG. 14(d), a film 82 (e.g., an Al film) made of the superconducting material is formed on the surface of the conductive film 83c attached to the lower surface of the insulating layer 80a by the plating method using a plating resist 84 as a mask. As illustrated in FIG. 14(e), the ground wiring 14a is formed by patterning the conductive film 83b on the upper surface of the insulating layer 80a. After the plating resist 84 is removed, the ground wiring 14b having the double-layer structure of the first layer 21 and the second layer 22 is formed by patterning the conductive film 83c on the lower surface of the insulating layer 80a. By forming the ground wiring 14b by the second forming method, the first layer 21 can be formed with high positional accuracy.

FIG. 13(b) is a cross-sectional view illustrating a second method of manufacturing the printed substrate 10b according to the second embodiment. As illustrated in FIG. 13(b), an insulating layer 80c having the ground wiring 14b including the first layer 21 and the second layer 22 formed on the upper surface thereof and the signal wiring 13 formed on the lower surface thereof is prepared. The ground wiring 14b and the signal wiring 13 are formed by the same method as the first forming method illustrated in FIGs. 14(a) and 14(b) or the second forming method illustrated in FIGs. 14(c) to 14(e). Insulating layers 81b and 81c are arranged on both sides of the insulating layer 80c, and the conductive film 83a of the normal conducting material is arranged outside the insulating layer 81b. The conductive film 87 in which the film 85 made of the superconducting material and the film 86 made of the normal conducting material are integrated is disposed outside the insulating layer 81c. Thereafter, the same steps as those of FIGs. 6(b) and 6(c) of the first embodiment are performed. Thus, the printed substrate 10b according to the second embodiment is formed.

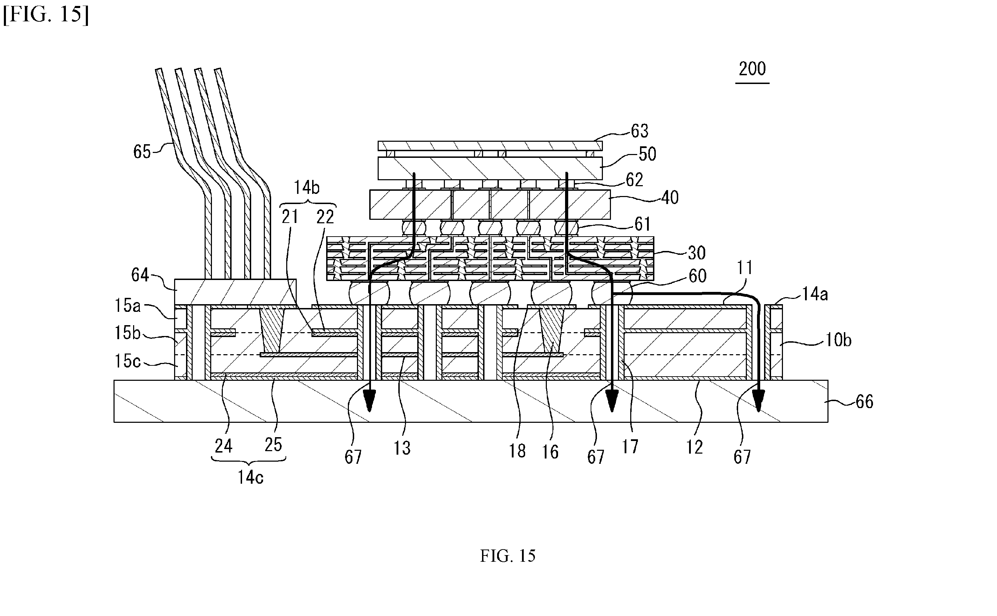

FIG. 15 is a cross-sectional view illustrating a cooling structure of a quantum device 200 according to the second embodiment. In FIG. 15, the printed substrate 10b is illustrated as a combination of FIGs. 12(a) and 12(b) for the sake of convenience. As illustrated in FIG. 15, the printed substrate 10b is disposed on the upper surface of the cooling plate 66. As a result, the second layer 25 of the ground wiring 14c exposed on the lower surface 12 of the printed substrate 10b is brought into contact with the cooling plate 66. Since the second layer 25 of the ground wiring 14c, the ground vias 17, and the ground wiring 14a are formed of the normal conducting material, the heat resistance is suppressed to be low even when they are cooled to the cryogenic temperature. Since the ground vias 17 are connected to the second layer 25 of the ground wiring 14c, the heat transfer between the quantum chip 50 and the cooling plate 66 as indicated by the arrows 67 is maintained even when the ground vias 17 and the second layer 25 are cooled to the cryogenic temperature. Therefore, the quantum chip 50 can be cooled to the cryogenic temperature.

[Modifications]

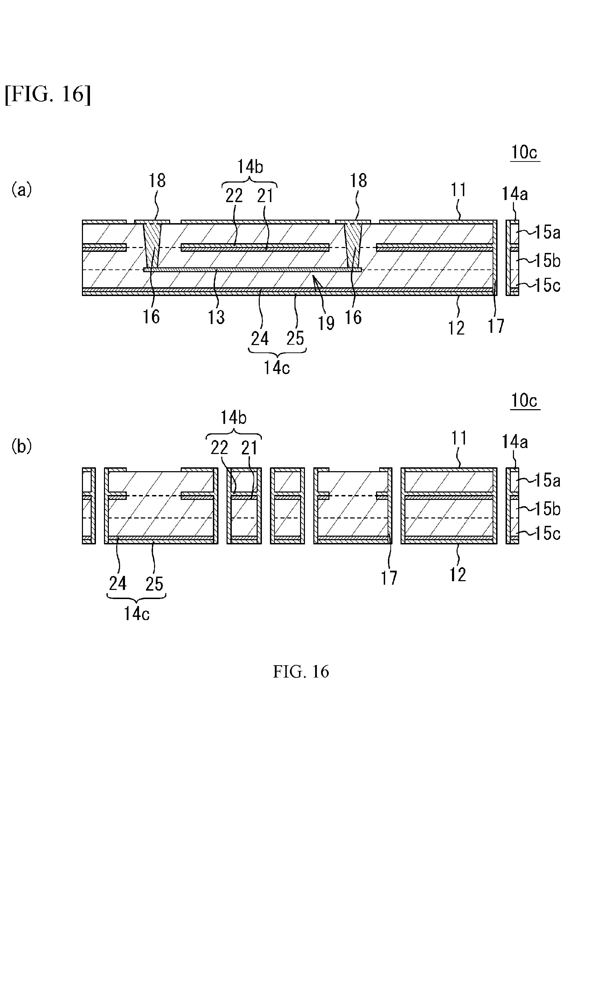

FIG. 16(a) and FIG. 16(b) are cross-sectional views of a printed substrate 10c in a modification of the second embodiment. As illustrated in FIG. 16(a) and FIG. 16(b), in the printed substrate 10c in the modification of the second embodiment, the ground wiring 14b includes the first layer 21 provided on the entire surface of the second layer 22 on the signal wiring 13 side. The ground wiring 14c is provided with the first layer 24 on the entire surface of the second layer 25 on the signal wiring 13 side. The other configurations are the same as those of the second embodiment, and thus the description thereof will be omitted.

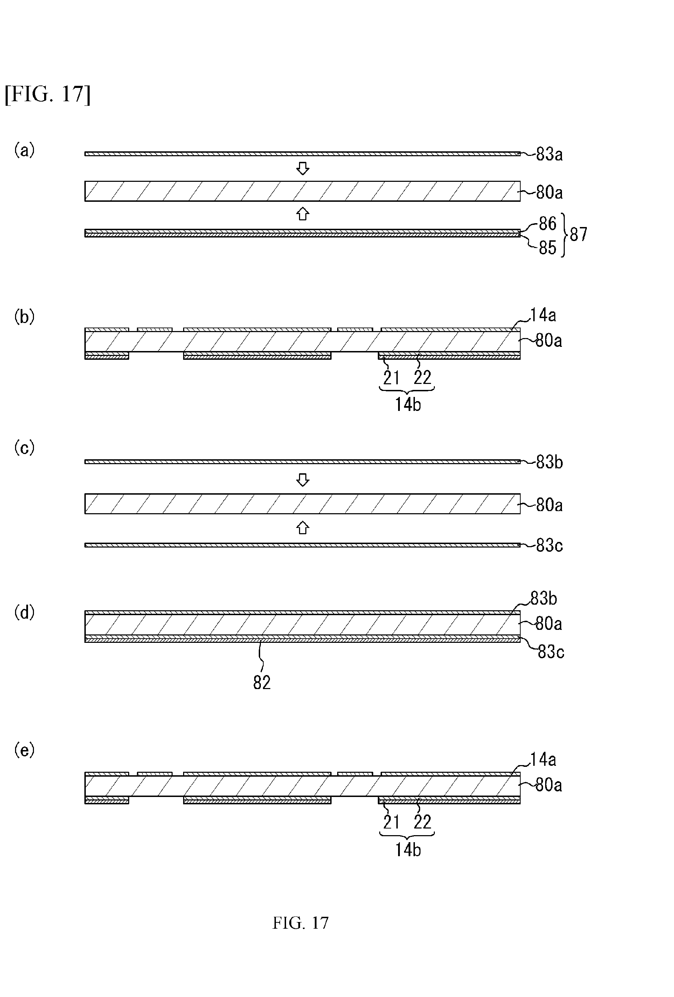

FIG. 17(a) and FIG. 17(b) are cross-sectional views illustrating a first method of forming the ground wiring 14b having the double-layer structure in the modification of the second embodiment, and FIG. 17(c) to FIG. 17(e) are cross-sectional views illustrating a second method of forming the ground wiring 14b having the double-layer structure in the modification of the second embodiment.

In the first forming method, as illustrated in FIG. 17(a), the conductive film 83a of the normal conducting material is attached to the upper surface of the insulating layer 80a. The conductive film 87 in which the film 85 made of the superconducting material and the film 86 made of the normal conducting material are integrated is attached to the lower surface of the insulating layer 80a. The conductive film 87 may be formed by using a conductive foil as the film 85 and plating the entire upper surface of the film 85 with the film 86, or may be formed by using a conductive foil as the film 86 and plating the entire upper surface of the film 86 with the film 85. Next, as illustrated in FIG. 17(b), the ground wiring 14a is formed by patterning the conductive film 83a on the upper surface of the insulating layer 80a. The ground wiring 14b having the double-layer structure of the first layer 21 and the second layer 22 is formed by patterning the conductive film 87 on the lower surface of the insulating layer 80a.

In the second forming method, as illustrated in FIG. 17(c), the conductive films 83b and 83c of the normal conducting material are attached to the upper surface and the lower surface of the insulating layer 80a. Next, as illustrated in FIG. 17(d), the film 82 made of the superconducting material is formed on the entire surface of the conductive film 83c attached to the lower surface of the insulating layer 80a by the plating method. As illustrated in FIG. 17(e), the ground wiring 14a is formed by patterning the conductive film 83b on the upper surface of the insulating layer 80a. The ground wiring 14b having the double-layer structure of the first layer 21 and the second layer 22 is formed by patterning the film 82 and the conductive film 83c on the lower surface of the insulating layer 80a.

In the case of forming the ground wiring 14c, in the first forming method, the film 85 made of the superconducting material and the film 86 made of the normal conducting material may be replaced with each other and attached to the insulating layer of the cured resin. In the second forming method, a conductive foil of the superconducting material is used for the conductive film 83c, and the film 82 made of the normal conducting material may be formed on the surface of the conductive film 83c by the plating method.

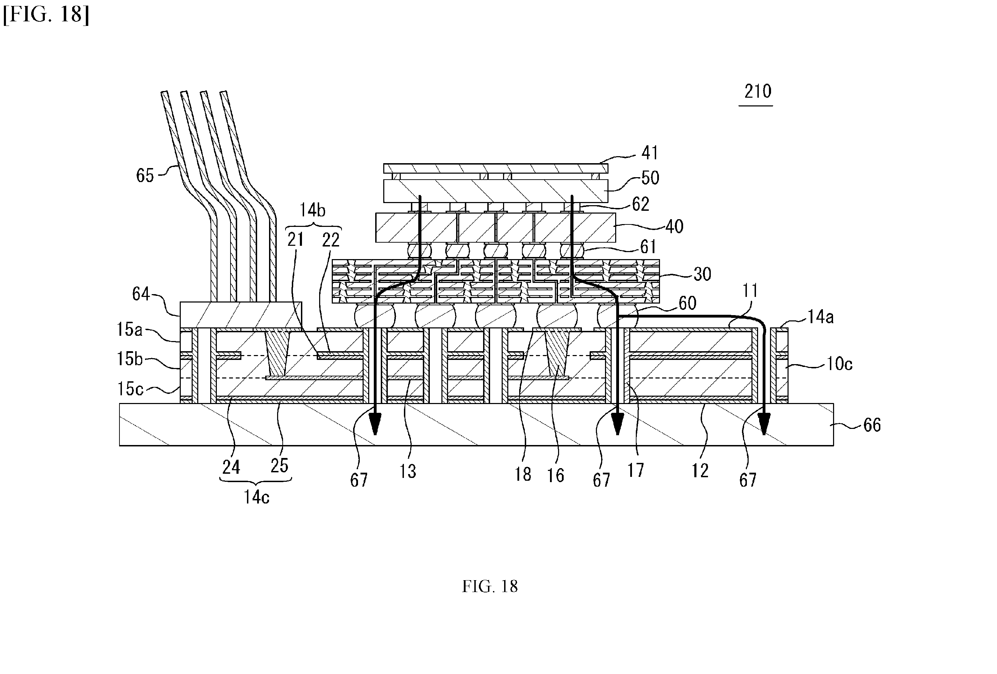

FIG. 18 is a cross-sectional view illustrating a cooling structure of a quantum device 210 according to a modification of the second embodiment. In FIG. 18, the printed substrate 10c is illustrated as a combination of FIGs. 16(a) and 16(b) for the sake of convenience. As illustrated in FIG. 18, the printed substrate 10c is disposed on the upper surface of the cooling plate 66. As a result, the second layer 25 of the ground wiring 14c exposed on the lower surface 12 of the printed substrate 10c is brought into contact with the cooling plate 66, as in the second embodiment. Since the ground vias 17 are connected to the second layer 25 of the ground wiring 14c, the heat transfer between the quantum chip 50 and the cooling plate 66 as indicated by the arrows 67 is maintained even when the ground vias 17 and the second layer 25 are cooled to the cryogenic temperature, as in the second embodiment. Therefore, the quantum chip 50 can be cooled to the cryogenic temperature.

In the second embodiment and the modifications thereof, the signal wiring 13 is formed of the superconducting material, as in the first embodiment and the modifications thereof. This can reduce the loss of the high frequency signal. As illustrated in FIGs. 12(b) and 16(b), the ground wiring 14a exposed on the upper surface 11 of the printed substrates 10b and 10c and the ground wiring 14c exposed on the lower surface 12 of the printed substrates 10b and 10c are connected to each other through the ground vias 17. The ground wirings 14a and 14c and the ground vias 17 are formed to include the normal conducting material. This makes it possible to cool the quantum chip 50 to the cryogenic temperature. Therefore, it is possible to reduce the loss while ensuring the coolability.

In the second embodiment and the modifications thereof, as illustrated in FIG. 12(a) and FIG. 16(a), the ground wiring 14b includes the first layer 21 and the second layer 22, and the ground wiring 14c includes the first layer 24 and the second layer 25. The first layers 21 and 24 are formed of the superconducting material and are provided to face the signal wiring 13. The second layers 22 and 25 are formed of the normal conducting material and are provided on the opposite side of the signal wiring 13 with respect to the first layers 21 and 24. In other words, in the second embodiment, as illustrated in FIG. 11(c) and FIG. 11(d), the second layers 22 and 25 are formed of the normal conducting material and are provided around the first layers 21 and 24 in plan view. Accordingly, the first layers 21 and 24 made of the superconducting material are present in the electromagnetic field of the strip line 19 through which the high frequency signal is transmitted, and thus the loss of the high frequency signal can be further reduced. In addition, in the ground wiring 14c, the second layer 25 made of the normal conducting material is exposed on the lower surface 12 of the printed substrates 10b and 10c, and the ground vias 17 are connected to at least the second layer 25 of the ground wiring 14c, so that the coolability of the quantum chip 50 can be ensured.

In the second embodiment and the modifications thereof, as illustrated in FIG. 11(c) and FIG. 11(e), the first layers 21 and 24 are provided to cover a range separated from the signal wiring 13 by at least three times the width W of the signal wiring 13 in plan view. Since the electromagnetic field of the strip line 19 concentrates within the range of three times the width W of the signal wiring 13 from the signal wiring 13, the loss of the high frequency signal can be further reduced by providing the first layers 21 and 24 over the range of at least three times the width W of the signal wiring 13 from the signal wiring 13. From the viewpoint of reducing the loss of the high frequency signal, the first layers 21 and 24 may be provided over the range of at least four times, six times, or eight times the width W of the signal wiring 13 from the signal wiring 13. For example, the lengths L1 and L2 in FIG. 11(c) may be 300 μm or more, may be 400 μm or more, or may be 500 μm or more.

In the modification of the second embodiment, as illustrated in FIGs. 16(a) and 16(b), the first layer 21 of the ground wiring 14b is provided on the entire surface of the second layer 22 on the signal wiring 13 side. The first layer 24 of the ground wiring 14c is provided on the entire surface of the second layer 25 on the signal wiring 13 side. This facilitates the formation of the ground wirings 14b and 14c having the double-layer structure of the first layers 21 and 24 and the second layers 22 and 25.

According to the manufacturing method of the second embodiment and the modifications thereof, as illustrated in FIG. 12(a) and FIG. 16(a), the multilayer body 72 is formed in which the signal wiring 13 faces the ground wiring 14c and the ground wiring 14b and is interposed between the ground wiring 14c and the ground wiring 14b (also referring to FIG. 5(b) and FIG. 6(b)). In this case, the ground wiring 14b includes the first layer 21 and the second layer 22, and the ground wiring 14c includes the first layer 24 and the second layer 25. The first layers 21 and 24 are formed of the superconducting material and are provided to face the signal wiring 13. The second layers 22 and 25 are formed of the normal conducting material and are provided on the opposite side of the signal wiring 13 with respect to the first layers 21 and 24. Accordingly, the first layers 21 and 24 made of the superconducting material are present in the electromagnetic field of the strip line 19, and thus the loss of the high frequency signal can be further reduced.

In the second embodiment and the modifications thereof, the ground wiring 14b includes the first layer 21 and the second layer 22, and the ground wiring 14c includes the first layer 24 and the second layer 25, but the present disclosure is not limited to this case. Either one of the ground wirings 14b and 14c may include the first layer and the second layer.

In the manufacturing methods of the second embodiment and the modifications thereof, as illustrated in FIGs. 13(a) and 13(b), the multilayer body 72 is formed using the insulating layers 80a and 80b and the insulating layer 81a or using the insulating layer 80c and the insulating layers 81b and 81c (also referring to FIGs. 5(b) and 6 (b)). As illustrated in FIGs. 14(a) and 14(b) and FIGs. 17(a) and 17(b), the ground wiring 14b is formed by attaching the conductive film 87, in which the film 85 made of the superconducting material and the film 86 made of the normal conducting material are integrated, to the insulating layer 80a, and setting the film 85 as the first layer 21 and the film 86 as the second layer 22. Alternatively, as illustrated in FIGs. 14(c) to 14(e) and FIGs. 17(c) to 17(e), the ground wiring 14b is formed by attaching the conductive film 83c, which is the normal conductive film, to the insulating layer 80a, and then forming the film 82 made of the superconducting material on the surface of the conductive film 83c, and setting the film 82 as the first layer 21 and the conductive film 83c as the second layer 22. This makes it possible to easily form the ground wiring 14b having the double-layer structure. As described above, when the ground wiring 14c is formed, the film 85 made of the superconducting material and the film 86 made of the normal conducting material are replaced with each other and are attached to the insulating layer of the cured resin in FIGs. 14(a), 14(b), 17(a), and 17(b). When the ground wiring 14c is formed, the superconducting material is used for the conductive film 83c, and the film 82 made of the normal conducting material is formed on the surface of the conductive film 83c by the plating method in FIGs. 14(c) to 14(e) and FIGs. 17 (c) to 17(e).

[Thickness of First Layer of Ground Wiring]

It is known that the high frequency signal flows intensively near the surface of a conductor and hardly flows in the center of the conductor. A range from the surface of the conductor through which the high frequency signal flows intensively is defined by a skin depth d according to the following Equation (1).

[Equation 1]

$$d = \sqrt{\dfrac{1}{\pi f \mu \sigma}} \quad \cdots \quad \textbf{(Equation1)}$$

In the formula (1), d is a skin depth [m]. F is a frequency [Hz]. M is a permeability [H/m]. $\sigma$ is a conductivity [S/m]. For example, when the conductor is made of Cu, the skin depth d at room temperature is about 2.07 $\mu$m for a high frequency signal of 1 GHz and about 0.66 $\mu$m for a high frequency signal of 10 GHz. When the conductor is made of Al, the skin depth d at room temperature is about 2.62 $\mu$m for the high frequency signal of 1 GHz and about 0.83 $\mu$m for the high frequency signal of 10 GHz.

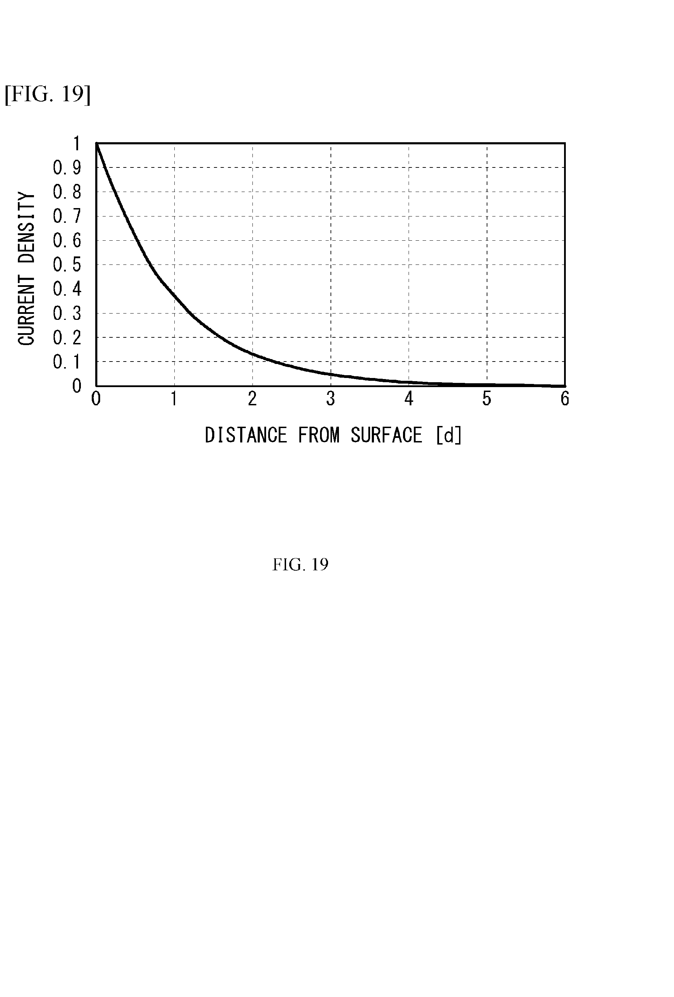

FIG. 19 is a diagram illustrating current density with respect to distance from the surface of the conductor. In FIG. 19, a horizontal axis represents a distance from the surface of the conductor, and a unit is represented by the skin depth d. A vertical axis represents a current density, and the current density on the surface of the conductor is represented as 1. As illustrated in FIG. 19, the current density decreases from the surface of the conductor toward the inside at $1/e^d$. Therefore, the current densities are attenuated by about 95% at a position of 3d, about 98% at a position of 4d, about 99% at a position of 5d, and about 99.75% at a position of 6d.

At the cryogenic temperature, $\sigma$ (conductivity) in the equation (1) becomes large, and in the case of Cu, for example, $\sigma$ is about 100 times larger than that at room temperature when the temperature becomes about 10 mK. In this case, the skin depth d is about 0.21 $\mu$m at 1 GHz and about 0.07 $\mu$m at 10GHz.

In the superconducting material such as Al, $\sigma$ is 10,000 times or more larger at about 10 mK than at room temperature. For example, when $\sigma$ is 10000 times, the skin depth d is about 0.026 $\mu$m at 1 GHz and about 0.008 $\mu$m at 10 GHz. At this time, the 3d is about 0.078 $\mu$m at 1 GHz, about 0.024 $\mu$m at 10 GHz, and the 4d is about 0.104 $\mu$m at 1 GHz, and about 0.032 $\mu$m at 10 GHz. The 5d is about 0.13 $\mu$m at 1 GHz, about 0.04 $\mu$m at 10 GHz, and the 6d is about 0.16 $\mu$m at 1 GHz, and about 0.048 $\mu$m at 10 GHz.

From the above, it can be said that in a conductor made of the superconducting material, most of the high frequency signal flows in a range of 0.01 $\mu$m from the surface of the conductor at the cryogenic temperature. In other words, it can be said that the depth to which the high frequency signal transmitted through the strip line penetrates into the ground wiring is approximately 0.01 $\mu$m.

In the second embodiment and the modifications thereof, the ground wiring 14b includes the second layer 22 made of Cu, and the first layer 21 made of Al and disposed on the surface 23 of the second layer 22 on the signal wiring 13 side. The ground wiring 14c includes the second layer 25 made of Cu, and the first layer 24 made of Al and provided on the surface 26 of the second layer 25 on the signal wiring 13 side. The high frequency signal transmitted through the strip line 19 penetrates into the regions of the ground wirings 14b and 14c on the signal line 13 side. From the viewpoint of suppressing the loss, it is preferable that most of the high frequency signal flows through the first layers 21 and 24 made of Al and hardly flows through the second layers 22 and 25 made of Cu. Therefore, in order to suppress the high frequency signal from penetrating into the second layers 22 and 25, it is preferable that the thicknesses of the first layers 21 and 24 are 0.01 $\mu$m or more from the consideration of the skin depth d recited above.

Therefore, in the second embodiment and the modifications thereof, the thicknesses of the first layers 21 and 24 of the ground wirings 14b and 14c are set to 0.01 $\mu$m or more. This makes it possible to further reduce the loss of the high frequency signal. From the viewpoint of reducing the loss, the thicknesses of the first layers 21 and 24 are preferably 0.05 $\mu$m or more, more preferably 0.1 $\mu$m or more, further preferably 0.5 $\mu$m or more, and still further preferably 1.0 $\mu$m or more. In other words, the thicknesses of the first layers 21 and 24 are preferably three times or more, more preferably four times or more, even more preferably five times or more, and still even more preferably six times or more the skin depth d obtained by the above formula (1). It is known that when a normal conductive metal and a superconducting metal are in contact with each other, a proximity effect occurring at their interface is on the order of 0.1 $\mu$m. Therefore, by setting the thicknesses of the first layers 21 and 24 to 0.5 $\mu$m or more, the influence of the proximity effect can also be suppressed, and it can be said that the electrical characteristics of the high frequency signal are generally determined by the characteristics of the superconducting material forming the first layers 21 and 24.

In the first embodiment, the second embodiment, and the modifications thereof, the signal wiring provided on the printed substrate includes the superconducting material, and the ground wirings and the ground vias include the normal conducting material, but the present disclosure is not limited to this. For example, the signal wiring provided on the package substrate in FIG. 1 may include the superconducting material, and the ground wirings and the ground vias may include the normal conducting material.

[Third Embodiment]

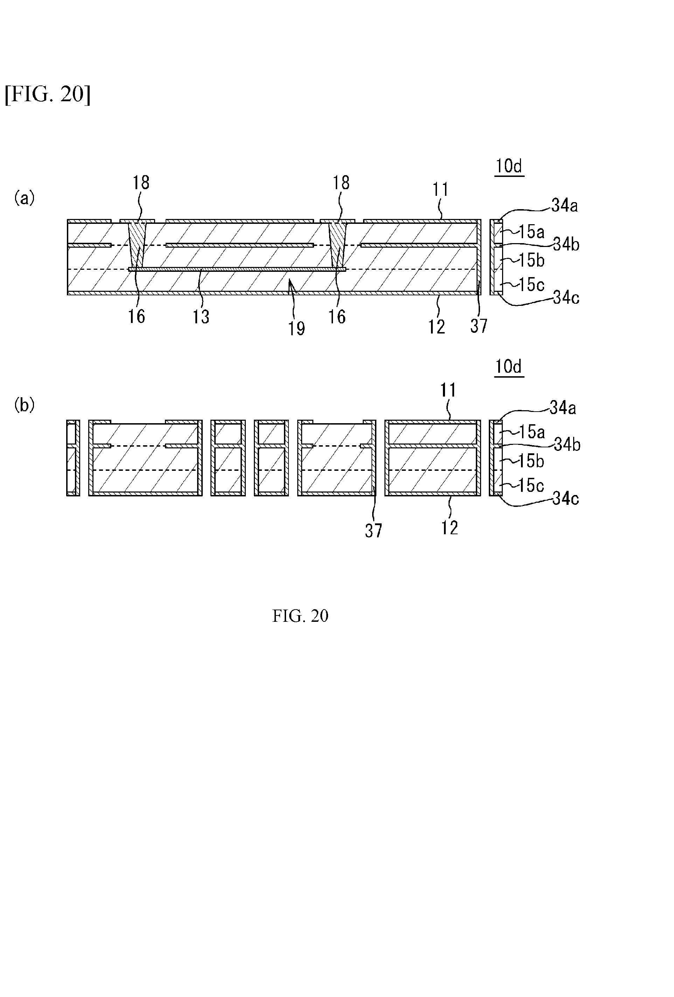

FIG. 20(a) and FIG. 20(b) are cross-sectional views of a printed substrate 10d in a third embodiment. As illustrated in FIG. 20(a) and FIG. 20(b), in the printed substrate 10d in the third embodiment, the ground wirings 34a, 34b, and 34c and the ground vias 37 made of the superconducting material to which a magnetic material is added are provided instead of the ground wirings 14a, 14b, and 14c and the ground vias 17 made of the normal conducting material. For example, the ground wirings 34a, 34b, and 34c and the ground vias 37 are made of aluminum (Al), titanium nitride (TiN), or niobium (Nb) to which at least one of Fe, Gd, Ni, and Co is added as the magnetic material. The additive amount of the magnetic materials is extremely small (for example, the number of atoms of about 0.01 atm%). The other configurations of the quantum device according to the third embodiment are the same as those of the quantum device 100 according to the first embodiment, and thus the illustration and description thereof are omitted.

In the third embodiment, the ground wirings 34a, 34b, and 34c and the ground vias 37 are formed to include the superconducting material to which the magnetic material is added. It is known that the superconducting transition temperature (Tc) of the superconducting material to which the magnetic material is added is, for example, about 10 mK (for example, Introduction to Solid State Physics, 8th edition, Charles Kittel, 10: Superconductivity p. 278 (Chapter10: Superconductivity p. 260)). That is, the superconducting material to which the magnetic material is added has a lower superconducting transition temperature than a superconducting material to which the magnetic material is not added. The Josephson junction element 56 included in the quantum chip 50 is formed of the superconducting material to which the magnetic material is not added. Therefore, when the ground wirings 34a, 34b, and 34c and the ground vias 37 are cooled to operate the quantum chip 50 in the superconducting state, the heat resistance is suppressed from increasing. Therefore, in the process of cooling the quantum chip 50, the heat transfer between the quantum chip 50 and the cooling plate 66 is maintained, and the quantum chip 50 can be cooled to the cryogenic temperature. Further, after the quantum chip 50 is cooled to the cryogenic temperature, the ground wirings 34a, 34b, and 34c are cooled to the superconducting transition temperature, and the ground wirings 34a, 34b, and 34c are brought into the superconducting state, so that the loss of the high frequency signal can be reduced. In addition, in cooling aimed at achieving a temperature around 10 mK, beryllium (Be) (Tc = 26 mK) or tungsten (W) (Tc = 12 mK) may be used in addition to the superconductor to which a small amount of magnetic materials is added.

In the third embodiment, the signal wiring 13 and the ground wiring 34b may be interchanged as in the modifications of the first embodiment illustrated in FIGs. 10(a) and 10(b). As in the second embodiment illustrated in FIGs. 12(a) and 12(b) and the modification of the second embodiment illustrated in FIGs. 16(a) and 16(b), the ground wirings 34b and 34c may include the first layer of the superconducting material and the second layer of the superconducting material to which the magnetic material is added.

In the third embodiment, the signal wiring provided on the printed substrate includes the superconducting material, and the ground wirings and the ground vias include the superconducting material to which the magnetic material is added. For example, the signal wiring provided on the package substrate in FIG. 1 may include the superconducting material, and the ground wirings and the ground vias may include the superconducting material to which the magnetic material is added.

Although the embodiment of the present invention is described in detail, the present invention is not limited to the specifically described embodiments and variations but other embodiments and variations may be made without departing from the scope of the claimed invention.

[Reference Signs List]

10, 10a, 10b, 10c, 10d... printed substrate, 11... upper surface, 12... lower surface, 13... signal line, 14a, 14b, 14c ... ground wiring, 15a, 15b, 15c ... insulating layer, 16 ... signal via, 17 ... ground via, 18 ... land, 19 ... strip line, 21 ... first layer, 22 ... second layer, 23 ... surface, 24 ... first layer, 25 ... second layer, 26 ... surface, 30... package substrate, 34a, 34b, 34c ... ground wiring, 37... ground via, 40... interposer, 50 ... quantum chip, 51 ... quantum bit, 52 ... quantum bit element, 53 ... resonator, 54 ... filter, 55a, 55b ... electrode, 56 ... Josephson junction element, 57a, 57b ... superconducting film, 58 ... insulating film, 59 ... readout unit, 60, 61, 62 ... bonding material, 63 ... cover chip, 64 ... connector, 65 ... cable, 66 ... cooling plate, 70a, 70b, 70c ... insulating layer (cured resin), 71a, 71b, 71c ... insulating layer (semi-cured resin), 72 ... multilayer body, 73 ... upper surface, 74 ... lower surface, 75 ... hole, 76 ... through hole, 77a, 77b ... conductive foil, 80a, 80b, 80c ... insulating layer (cured resin), 81a, 81b, 81c ... insulating layer (semi-cured resin), 82 ... film, 83a, 83b, 83c ... conductive film, 84 ... plating resist, 85 ... film, 86 ... film, 87 ... conductive film, 90 ... strip line, 91 ... signal wiring, 92 ... ground wiring, 93 ... dielectric layer, 100, 200, 210 ... quantum device

## Claims

1. A quantum device comprising:

    a multilayer wiring substrate including a first wiring including a superconducting material, a second wiring including a normal conducting material, and a via connected to the second wiring and including a normal conducting material; and
    a quantum chip provided on a first surface of the multilayer wiring substrate and electrically connected to the first wiring and the via;
    wherein the via is formed so as to penetrate from the first surface to a second surface of the multilayer wiring substrate, and

the second wiring is formed so as to be exposed on the second surface of the multilayer wiring substrate.

2. The quantum device according to claim 1,
wherein the first wiring is a signal wiring, and the second wiring is a ground wiring.

3. The quantum device according to claim 1 or 2, further comprising

a third wiring formed on the first surface of the multilayer wiring substrate and including a normal conducting material,
wherein the via connects the second wiring and the third wiring to each other.

4. The quantum device according to claim 3,
wherein the first wiring is provided inside the multilayer wiring substrate, and at least a part of the first wiring overlaps both the second wiring and the third wiring in plan view.

5. The quantum device according to claim 3,

wherein the first wiring is provided to face one wiring of the second wiring and the third wiring,
the quantum device includes a fourth wiring facing the first wiring and interposing the first wiring with the fourth wiring and the one wiring, and
a strip line is formed by the first wiring, the one wiring, and the fourth wiring.

6. The quantum device according to claim 5,

wherein at least one of the one wiring and the fourth wiring includes a first layer provided to face the first wiring and including a superconducting material, and a second layer provided opposite to the first wiring with respect to the first layer and including a normal conducting material, and
the via is connected to the second layer.

7. The quantum device according to claim 5, wherein

wherein at least one of the one wiring and the fourth wiring includes a first layer including provided to face the first wiring and including a superconducting material, and a second layer provided around the first layer in plan view and including a normal conducting material, and
the via is connected to the second layer.

8. The quantum device according to claim 6,
wherein the first layer is provided to cover a range separated from the first wiring by at least three times a width of the first wiring in plan view.

9. The quantum device according to claim 6,
wherein the first layer is provided on an entire surface of the second layer on a first wiring side.

10. The quantum device according to claim 6,
wherein the first layer has a thickness of 0.01 $\mu$m or more.

11. The quantum device according to claim 5,
wherein the one wiring is the third wiring.

12. The quantum device according to claim 1 or 2,

wherein the multilayer wiring substrate further includes a signal via connected to the first wiring, and
the signal via includes a superconducting material.

13. The quantum device according to claim 1 or 2,

wherein the multilayer wiring substrate further includes a signal via connected to the first wiring, and
the signal via includes a normal conducting material.

14. The quantum device according to claim 1 or 2,

wherein the first wiring includes aluminum, titanium nitride, or niobium as the superconducting material, and the second wiring and the via include copper as the normal conducting material.

15. A quantum device comprising:

a multilayer wiring substrate including a first wiring including a superconducting material, a second wiring including a superconducting material to which a magnetic material is added, and a via connected to the second wiring and including a superconducting material to which a magnetic material is added; and
a quantum chip provided on a first surface of the multilayer wiring substrate and electrically connected to the first wiring and the via;
wherein the via is formed so as to penetrate from the first surface to a second surface of the multilayer wiring substrate, and
the second wiring is formed so as to be exposed on the second surface of the multilayer wiring substrate.

16. The quantum device according to claim 15,

wherein the first wiring includes aluminum, titanium nitride, or niobium as the superconducting material, and the second wiring and the via include aluminum, titanium nitride, or niobium to which at least one of iron, gadolinium, nickel, or cobalt is added as the superconducting material to which the magnetic material is added.

17. A method of manufacturing a multilayer wiring substrate comprising:

forming a multilayer body in which a signal wire including a superconducting material and a plurality of ground wirings including normal a conducting material are laminated with a plurality of insulating layers interposed therebetween, wherein a first ground wiring out of the plurality of ground wirings is exposed on a first surface of the multilayer body and a second ground wiring out of the plurality of ground wirings is exposed on a second surface opposite to the first surface; and
forming a ground via in the multilayer body, the ground via including a normal conducting material and connecting the first ground wiring and the second ground wiring.

18. The method of manufacturing the multilayer wiring substrate according to claim 17,

wherein the forming the multilayer body includes forming the multilayer body in which the signal wiring faces one ground wiring out of the first ground wiring and the second ground wiring, and a third ground wiring out of the plurality of ground wirings faces the signal wiring and the signal wiring is interposed between the one ground wiring and the third ground wiring,
wherein at least one ground wiring out of the one ground wiring and the third ground wiring includes a first layer made of a superconducting material and provided to face the signal wiring, and a second layer made of a normal conducting material and provided opposite to the signal wiring with respect to the first layer.

19. The method of manufacturing the multilayer wiring substrate according to claim 18,

wherein the forming the multilayer body includes forming the multilayer body using a cured first insulating layer, and a second insulating layer in a semi-cured state, and
the at least one ground wiring is formed by attaching a film in which a film made of a superconducting material and a film made of a normal conducting material are integrated to the first insulating layer, and setting the film made of the superconducting material as the first layer and the film made of the normal conducting material as the second layer.

20. The method of manufacturing the multilayer wiring substrate according to claim 18,

wherein the forming multilayer body includes forming the multilayer body using a cured first insulating layer and a second insulating layer in a semi-cured state, and
the at least one ground wiring is formed by attaching a film made of one of a superconducting material and a normal conducting material to the first insulating layer, then forming a film made of another of the superconducting material and the normal conducting material on a surface of the film made of the one thereof, and setting the film made of the superconducting material as the first layer and the film made of the normal conducting material as the second layer, out of the film made of the one thereof and the film made of the another thereof.

[FIG. 1]

FIG. 1

[FIG. 2]

(a)

51

54　　　　53　　　55a　55b

59

52　56

(b)

56

A →

57a

57b

A →

(c)

58　57a

57b

FIG. 2

[FIG. 3]

10

(a)

18  15a

B —— —— B

A —— —— A

~14a

17

D2

I  I

D1

(b)

~14b

15b  16  17

(c)

L

W

~15c

13  17

(d)

~14c

17

FIG. 3

[FIG. 4]

FIG. 4

[FIG. 5]

(a)

~14a
~70a
~14b

~71a

~13
~70b
~14c

(b)

72
73
~14a
~15a
~14b
~15b
~15c
~14c
13
74

10

(c)

75 18
11
76
~14a
~15a
~14b
~15b
~15c
~14c
13
16
12
17

FIG. 5

[FIG. 6]

(a)

(b)

(c)

FIG. 6

[FIG. 7]

90

FIG. 7

[FIG. 8]

FIG. 8

[FIG. 9]

FIG. 9

[FIG. 10]

FIG. 10

[FIG. 11]

FIG. 11

[FIG. 12]

FIG. 12

[FIG. 13]

(a)

14a
80a

21 22
14b

81a

13
80b

24 25
14c

(b)

83a

81b

14b
21 22

80c

13

81c

85 86
87

FIG. 13

[FIG. 14]

(a)

~83a

⇩

~80a

⇧

85 86
87

(b)

14a
~80a

21 22
14b

(c)

~83b

⇩

~80a

⇧

~83c

(d)

83b
~80a
~83c

82

84

(e)

14a
~80a

21 22
14b

FIG. 14

[FIG. 15]

FIG. 15

EP 4 756 869 A1

[FIG. 16]

FIG. 16

[FIG. 17]

(a)

83a

80a

86
85 } 87

(b)

14a
80a

21  22
14b

(c)

83b

80a

83c

(d)

83b
80a
83c

82

(e)

14a
80a

21  22
14b

FIG. 17

[FIG. 18]

FIG. 18

[FIG. 19]

FIG. 19

[FIG. 20]

(a)

10d

18    18    11    34a
15a
34b
15b
15c
34c

16    13    19    16    12    37

(b)

10d

11    34a
15a
34b
15b
15c
34c

37    12

FIG. 20

## INTERNATIONAL SEARCH REPORT

International application No.

**PCT/JP2023/027712**

### A. CLASSIFICATION OF SUBJECT MATTER

*H01L 23/12*(2006.01)i; *H05K 1/09*(2006.01)i; *H05K 3/46*(2006.01)i; *H10N 60/80*(2023.01)i
FI:   H01L23/12 301J; H01L23/12 Q; H10N60/80 A; H05K1/09 A; H05K3/46 S

According to International Patent Classification (IPC) or to both national classification and IPC

### B. FIELDS SEARCHED

Minimum documentation searched (classification system followed by classification symbols)

H01L23/12; H05K1/09; H05K3/46; H10N60/80

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2022-2235 A (NEC CORPORATION) 06 January 2022 (2022-01-06)<br>entire text, all drawings | 1-20 |

☐ Further documents are listed in the continuation of Box C.      ☑ See patent family annex.

| | |
|---|---|
| *    Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **29 September 2023** | **10 October 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2023/027712**

| Patent document cited in search report | | | Publication date (day/month/year) | Patent family member(s) | | | Publication date (day/month/year) |
|---|---|---|---|---|---|---|---|
| JP | 2022-2235 | A | 06 January 2022 | US | 2021/0399195 | A1 | |
| | | | | entire text, all drawings | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5226901 A
- JP 2020535660 A
- JP 10224110 A